# EUROPÄISCHE PATENTSCHRIFT

(11) **EP 2 764 558 B1**
(45) Veröffentlichungstag und Bekanntmachung des Hinweises auf die Patenterteilung: **27.02.2019**
(21) Anmeldenummer: 12759018.0
(22) Anmeldetag: 08.09.2012
(51) Int. Cl.: H01L 51/50

(54) **ORGANISCHE ELEKTROLUMINESZENZVORRICHTUNG**
ORGANIC ELECTROLUMINESCENT DEVICE
DISPOSITIF ÉLECTROLUMINESCENTS ORGANIQUES

(30) Priorität: 06.10.2011 EP 11008083
(43) Veröffentlichungstag der Anmeldung: 13.08.2014
(73) Patentinhaber: Merck Patent GmbH, 64293 Darmstadt (DE)
(72) Erfinder: KAISER, Joachim, 64293 Darmstadt (DE); BOEHM, Edgar, 64347 Griesheim (DE)
(86) Internationale Anmeldenummer: PCT/EP2012/003775
(87) Internationale Veröffentlichungsnummer: WO 2013/050101

(56) Entgegenhaltungen:
- EP-A1- 1 999 803
- DE-A1-102009 012 346
- US-A1- 2006 040 132
- US-A1- 2006 214 568
- US-A1- 2009 191 427
- FUH-SHYANG JUANG ET AL: "Power Efficiency Improvement of White Phosphorescent Organic Light-Emitting Diode with Thin Double-Emitting Layers and Hole-Trapping Mechanism", JAPANESE JOURNAL OF APPLIED PHYSICS, THE JAPAN SOCIETY OF APPLIED PHYSICS, JAPAN SOCIETY OF APPLIED PHYSICS, TOKYO; JP, Bd. 50, Nr. 4.2, 1. April 2011 (2011-04-01), Seiten 4DK04-1, XP001573549, ISSN: 0021-4922, DOI: 10.1143/JJAP.50.04DK04 [gefunden am 2011-04-20]

## Beschreibung

Die vorliegende Erfindung betrifft organische Elektrolumineszenzvorrichtungen mit mindestens zwei emittierenden Schichten, wobei die zwei emittierenden Schichten phosphoreszierende Dotanden enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Eine Entwicklung im Bereich organischer Elektrolumineszenzvorrichtungen sind weiß emittierende OLEDs. Diese können entweder für monochrom weiße Displays oder mit Farbfilter für Vollfarbdisplays eingesetzt werden. Weiterhin eignen sie sich für Beleuchtungsanwendungen. Weiß emittierende organische Elektrolumineszenzvorrichtungen auf Basis niedermolekularer Verbindungen weisen im Allgemeinen mindestens zwei Emissionsschichten auf. Dabei werden Elektrolumineszenzvorrichtungen mit genau zwei Emissionsschichten insbesondere für Passiv-Matrix-Anwendungen verwendet, wobei hierfür häufig gemäß Stand der Technik nur fluoreszierende Emitter verwendet werden. Meist weisen die Elektrolumineszenzvorrichtungen mindestens drei Emissionsschichten auf, welche blaue, grüne und orange oder rote Emission zeigen. In den Emissionsschichten werden entweder fluoreszierende oder phosphoreszierende Emitter verwendet, wobei die phosphoreszierenden Emitter aufgrund der höheren erreichbaren Effizienz deutliche Vorteile zeigen. Der allgemeine Aufbau einer derartigen weiß emittierenden OLED mit mindestens einer phosphoreszierenden Schicht ist beispielsweise in WO 2005/011013 beschrieben. Wegen der höheren erreichbaren Effizienz wäre eine weiß emittierende OLED, welche nur phosphoreszierende Emitterschichten enthält, wünschenswert. Da blau phosphoreszierende Emitter jedoch den gängigen Anforderungen, insbesondere hinsichtlich der Betriebslebensdauer, in der Regel noch nicht genügen, werden nach dem Stand der Technik in den meisten Anwendungen Hybrid-OLEDs verwendet, d. h. eine fluoreszierende blaue Emitterschicht kombiniert mit phosphoreszierenden orange oder roten und grünen Emitterschichten (im Fall von Dreifarben-Weiß) oder eine fluoreszierende blaue Emitterschicht kombiniert mit einer phosphoreszierenden gelben bis orange Emitterschicht (im Fall von Zweifarben-Weiß).

Ein grundsätzliches Problem derartiger Hybrid-OLEDs besteht darin, dass gängige Matrix- und Emittermaterialien, welche in der blau fluoreszierenden Emitterschicht verwendet werden, im Allgemeinen ein zu niedriges Triplett-Niveau für phosphoreszierende Dotanden aufweisen, was dazu führen kann, dass Triplettexzitonen über die blaue Emitterschicht gelöscht werden. Dies führt zu einer geringeren Effizienz der OLED. Um maximale Effizienz aus einer weißen Hybrid-OLED zu erhalten, muss dafür Sorge getragen werden, diese Auslöschung von Triplettexzitonen zu verhindern. Dies ist möglich durch Verwendung einer organischen Zwischenschicht zwischen der phosphoreszierenden und der fluoreszierenden Emitterschicht. Allerdings werden an die Materialien einer solchen Zwischenschicht sehr hohe Anforderungen gestellt, damit diese einerseits die Auslöschung von Triplettexzitonen verhindern, auf der anderen Seite aber auch keine negativen Auswirkungen auf Effizienz, Lebensdauer oder Spannung der organischen Elektrolumineszenzvorrichtung haben, so dass es schwierig sein kann, eine solche Zwischenschicht zu realisieren.

Eine weitere Möglichkeit nach Stand der Technik, die Auslöschung von Triplettexzitonen über die fluoreszierende Schicht zu verhindern, besteht darin, die OLED als so genannte "stacked OLED" bzw. "Tandem-OLED" zu realisieren, wobei die phosphoreszierende Schicht bzw. die phosphoreszierenden Schichten in einer der elektrolumineszierenden Einheiten und die fluoreszierende Schicht bzw. die fluoreszierenden Schichten in einer anderen der elektrolumineszierenden Einheiten angeordnet sind (z. B. Y.-S. Tyan et al., SID-Symposium Digest, 2009, 895). Dadurch kann ein direkter Kontakt zwischen der fluoreszierenden Emitterschicht und der phosphoreszierenden Emitterschicht verhindert werden. Dieser Aufbau hat den Vorteil, dass keine organische Zwischenschicht (Interlayer) zwischen der fluoreszierenden und der phosphoreszierenden Emitterschicht erforderlich ist. Weiterhin ist jede einzelne elektrolumineszierende Einheit der Tandem-OLED einer geringeren Strombelastung ausgesetzt, als dies der Fall wäre, wenn alle emittierenden Schichten direkt aufeinander angeordnet wären.

In einer Tandem-OLED sind zwei oder mehrere elektrolumineszierende Einheiten vertikal in Serie geschaltet, wobei zwischen den einzelnen elektrolumineszierenden Einheiten Ladungserzeugungsschichten vorliegen (z. B. T.-W. Lee et al., Appl. Phys. Lett. 2008, 92, 043301). Die Ladungserzeugungsschicht wird üblicherweise dadurch gebildet, dass eine n-leitende Schicht (bzw. eine leitende Elektroneninjektionsschicht) und eine p-leitende Schicht (bzw. eine leitende Lochinjektionsschicht) miteinander gekoppelt werden. Die p-leitenden Schichten, die gemäß dem Stand der Technik verwendet werden, umfassen beispielsweise p-dotierte organische Lochtransportmaterialien, wobei der Dotand beispielsweise F₄-TCNQ oder WO₃ ist, oder anorganische Materialien, wie zum Beispiel Indium-Zinn-Oxid (ITO), V₂O₅, WO₃ oder MoO₃. Die n-leitende Schicht ist im Allgemeinen eine dotierte organische Elektronentransportschicht, wobei als Dotand Metalle mit geringer Austrittsarbeit, wie zum Beispiel Cs, Li oder Mg, oder Metallcarbonate verwendet werden.

Im Allgemeinen ist es nicht ausreichend, in der phosphoreszierenden Emitterschicht nur einen gelb phosphoreszierenden Dotanden zu verwenden. So werden üblicherweise in der phosphoreszierenden elektrolumineszierenden Einheit der Tandem-OLED ein grün phosphoreszierender Dotand und ein orange oder ein rot phosphoreszierender Dotand kombiniert. Dies kann entweder dadurch erfolgen, dass beide Dotanden in dieselbe Emitterschicht eindotiert werden oder dass die beiden Dotanden in separaten Emitterschichten vorliegen. Bei beiden Methoden gibt es jedoch Nachteile. So erhält man eine vergleichsweise schlechte Lebensdauer, wenn beide phosphoreszierenden Emitter in eine Emitterschicht eindotiert sind. Liegen dagegen die beiden phosphoreszierenden Emitter in zwei separaten Emitterschichten vor, erhält man zwar eine gute Lebensdauer, beobachtet jedoch einen starken Farbshift mit der Lebensdauer, welcher nicht auf die Alterung eines der Emitter zurückgeführt werden kann.

Aus F.-S. Juang et al. (Jap. J. Appl. Phys. 2011, 50, 4DK04-1) ist eine weiß emittierende OLED mit blau und organge phoshoreszierenden Emissionsschichten und mit einem speziellen Deviceaufbau bekannt. Aus US 2006/0214568 ist eine weiß emittierende OLED mit blau, grün und rot phosphoreszierenden Emissionsschichten und einem speziellen Deviceaufbau bekannt. Keines dieser Dokumente offenbart eine Tandem-OLED, welche in dem einem Teil der Tandem-OLED eine blau fluoreszierende Emitterschicht und in dem anderen Teil der Tandem-OLED zwei phosphoreszierende Emitterschichten aufweist.

Aus US 2006/0040132 ist bekannt, dass die Eigenschaften einer weiß emittierenden OLED durch die Verwendung einer Tandem-OLED mit zwei weiß emittierenden Einheiten und einer Ladungserzeugungsschicht verbessert werden können.

Da es im Allgemeinen in der Praxis kein Fortschritt ist, wenn nur die Betriebslebensdauer verbessert wird, dies aber mit einem größeren Farbshift einhergeht, besteht das der vorliegenden Erfindung zu Grunde liegende technische Problem daher darin, eine Devicearchitektur für diese beiden phosphoreszierenden Schichten bereitzustellen, welche eine vergleichbar gute oder verbesserte Lebensdauer der phosphoreszierenden Emissionseinheit und gleichzeitig einen geringen Farbshift mit der Lebensdauer aufweist.

Überraschend wurde gefunden, dass eine OLED mit dem unten definierten Aufbau dieses Problem löst und zu einem sehr geringen Farbshift bei gleichzeitig einer sehr guten Lebensdauer führt.

Gegenstand der Erfindung ist somit eine organische Elektrolumineszenzvorrichtung, enthaltend in dieser Reihenfolge: Anode, phosphoreszierende Emitterschicht 1, phosphoreszierende Emitterschicht 2, die mit Emitterschicht 1 in direktem Kontakt steht, und Kathode, dadurch gekennzeichnet, dass Emitterschicht 1 ein lochleitendes Matrixmaterial und zwei unterschiedliche phosphoreszierende Emitter enthält und Emitterschicht 2 ein elektronenleitendes Matrixmaterial und einen phosphoreszierenden Emitter enthält, wobei der phosphoreszierende Emitter der Emitterschicht 2 dasselbe Emissionsmaximum hat wie der kürzerwellig phosphoreszierende Emitter der Emitterschicht 1, dadurch gekennzeichnet, dass es sich um eine weiß emittierende Tandem-OLED handelt, die zusätzlich eine blau fluoreszierende Emitterschicht aufweist und die zwischen der blau fluoreszierenden Emitterschicht und der Emitterschicht 2 eine Ladungserzeugungsschicht aufweist.

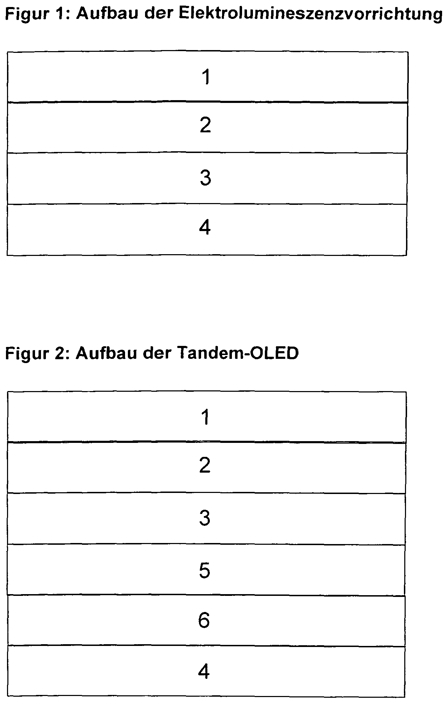

Der Aufbau des Teils der OLED, der Emitterschicht 1 und 2 aufweist, ist schematisch in Figur 1 dargestellt. Dabei bedeutet **1** die Anode, **2** die Emitterschicht 1, enthaltend ein lochleitendes Matrixmaterial und zwei unterschiedliche phosphoreszierende Emitter, **3** die Emitterschicht 2, enthaltend ein elektronenleitendes Matrixmaterial und den kürzerwellig phosphoreszierenden Emitter, und **4** die Kathode. Die OLED kann auch noch weitere Schichten enthalten, die nicht in Figur 1 abgebildet sind. Es handelt sich erfindungsgemäß um eine Tandem-OLED. Diese ist schematisch in Figur 2 dargestellt. Dabei bedeutet **1** die Anode, **2** die Emitterschicht 1, enthaltend ein lochleitendes Matrixmaterial und zwei unterschiedliche phosphoreszierende Emitter, **3** die Emitterschicht 2, enthaltend ein elektronenleitendes Matrixmaterial und den kürzerwellig phosphoreszierenden Emitter, **5** eine Ladungserzeugungsschicht, die auch aus mehreren Einzelschichten zusammengesetzt sein kann, **6** eine blau fluoreszierende Schicht und **4** die Kathode.

Ein Matrixmaterial im Sinne der vorliegenden Erfindung ist ein Material, das in einer Emissionsschicht verwendet werden kann, um darin das emittierende Material in typischerweise einer Volumenkonzentration von < 25 % einzudotieren, das aber selbst, im Gegensatz zum eindotierten Emittermaterial, nicht signifikant zur Lichtemission beiträgt. Welche Materialien in einer Emitterschicht signifikant zur Lichtemission beitragen und welche nicht, und welche Materialien damit als Emitter und welche als Matrixmaterialien anzusehen sind, kann durch einen Vergleich des Elektrolumineszenzspektrums der OLED, in der die Emitterschicht vorhanden ist, mit Photolumineszenzspektren der einzelnen Materialien erkannt werden. Dabei wird das Photolumineszenzspektrum der einzelnen Materialien in Lösung in einer Konzentration von 1.5 mg in 250 ml Lösemittel gemessen, wobei die Messung bei Raumtemperatur erfolgt und jedes Lösemittel geeignet ist, in dem sich die Substanz in der genannten Konzentration löst. Besonders geeignete Lösemittel sind üblicherweise Toluol, aber auch Dichlormethan.

Eine phosphoreszierende Verbindung im Sinne dieser Erfindung, wie sie in der phosphoreszierenden Emitterschicht der erfindungsgemäßen organischen Vorrichtung vorliegt, ist eine Verbindung, welche bei Raumtemperatur Lumineszenz aus einem angeregten Zustand mit Spinmultiplizität > 1 zeigt, insbesondere aus einem angeregten Triplettzustand. Im Sinne dieser Erfindung sollen alle lumineszierenden Übergangsmetallkomplexe, insbesondere alle lumineszierenden Iridium-, Platin- und Kupferverbindungen, als phosphoreszierende Verbindungen angesehen werden.

Eine fluoreszierende Verbindung im Sinne dieser Erfindung, wie sie beispielsweise als Emitter in einer der elektrolumineszierenden Einheiten einer Tandem-OLED vorliegen kann, ist eine Verbindung, welche bei Raumtemperatur Lumineszenz aus einem angeregten Singulett-Zustand zeigt. Im Sinne dieser Erfindung sollen insbesondere alle lumineszierenden Verbindungen, die nur aus den Elementen C, H, N, O, S, F, B und P aufgebaut sind, als fluoreszierende Verbindungen verstanden werden.

Die organische Elektrolumineszenzvorrichtung muss nicht notwendigerweise nur Schichten enthalten, welche aus organischen oder metallorganischen Materialien aufgebaut sind. So ist es auch möglich, dass Anode, Kathode, Ladungserzeugungsschichten und/oder eine oder mehrere weitere Schichten anorganische Materialien enthalten oder ganz aus anorganischen Materialien aufgebaut sind.

Im Sinne der vorliegenden Erfindung bedeutet "kürzerwellig phosphoreszierender Emitter", dass der Emitter in der Photolumineszenz ein Emissionsmaximum mit einer geringeren Wellenlänge als der andere phosphoreszierende Emitter aufweist. Dabei wird das Photolumineszenzspektrum der einzelnen Materialien in Lösung in einer Konzentration von 1.5 mg in 250 ml Lösemittel gemessen, wobei die Messung bei Raumtemperatur erfolgt und jedes Lösemittel geeignet ist, in dem sich die Substanz in der genannten Konzentration löst. Besonders geeignete Lösemittel sind üblicherweise Toluol, aber auch Dichlormethan. In einer bevorzugten Ausführungsform der Erfindung liegt das Emissionsmaximum des kürzerwellig phosphoreszierenden Emitters bei zwischen 10 und 140 nm kürzerer Wellenlänge als das des längerwellig phosphorezierenden Emitters, besonders bevorzugt bei zwischen 50 und 110 nm kürzerer Wellenlänge als das des längerwellig phosphorezierenden Emitters.

Im Sinne der vorliegenden Erfindung bedeutet "dasselbe Emissionsmaximum", dass das Emissionsmaximum der Emitter in der Photolumineszenz um maximal 10 nm voneinander abweicht. Dabei wird das Photolumineszenzspektrum gemessen, wie oben beschrieben.

In einer bevorzugten Ausführungsform der Erfindung ist der phosphoreszierende Emitter in der Emitterschicht 2 identisch zum kürzerwellig phosphoreszierenden Emitter in der Emitterschicht 1.

In einer bevorzugten Ausführungsform der Erfindung handelt es sich bei der phosphoreszierenden Emitterschicht 1 um eine gelb, orange oder rot emittierende Schicht und bei der phosphoreszierenden Emitterschicht 2 um eine grün oder gelb emittierende Schicht.

Dabei wird unter einer gelb emittierenden Schicht eine Schicht verstanden, deren Photolumineszenzmaximum im Bereich von 540 bis 570 nm liegt. Unter einer orange emittierenden Schicht wird eine Schicht verstanden, deren Photolumineszenzmaximum im Bereich von 570 bis 600 nm liegt. Unter einer rot emittierenden Schicht wird eine Schicht verstanden, deren Photolumineszenzmaximum im Bereich von 600 bis 750 nm liegt. Unter einer grün emittierenden Schicht wird eine Schicht verstanden, deren Photolumineszenzmaximum im Bereich von 490 bis 540 nm liegt. Unter einer blau emittierenden Schicht wird eine Schicht verstanden, deren Photolumineszenzmaximum im Bereich von 440 bis 490 nm liegt. Dabei wird das Photolumineszenzmaximum der Schicht durch Messung des Photolumineszenzspektrums der Schicht mit einer Schichtdicke von 50 nm bestimmt, wobei die Schicht dieselbe Zusammensetzung aufweist wie in der organischen Elektrolumineszenzvorrichtung, also Emitter und Matrix enthält.

In einer bevorzugten Ausführungsform der Erfindung emittieren die beiden erfindungsgemäßen Emitterschichten, Emitterschicht 1 und Emitterschicht 2, in Summe Licht mit Farbkoordinaten 0.45 ≤ CIE x ≤ 0.58 und bevorzugt 0.48 ≤ CIE x ≤ 0.55.

Ein lochleitendes Material im Sinne der vorliegenden Erfindung, wie es als Matrixmaterial in Emitterschicht 1 verwendet wird, ist bevorzugt ein Material, welches ein HOMO (highest occupied molecular orbital) von ≥ -5.5 eV, bevorzugt ≥ -5.3 eV aufweist. Dabei wird das HOMO durch quantenchemische Rechnung bestimmt, wie hinten im Beispielteil ausführlich allgemein beschrieben.

Die Triplettenergie T₁ des lochleitenden Matrixmaterials ist bevorzugt ≥ 2.3 eV, besonders bevorzugt ≥ 2.6 eV. Dabei sollte die Triplettenergie T₁ größer sein als die des langwelligsten Emitters.

Ein elektronenleitendes Material im Sinne der vorliegenden Erfindung, wie es als Matrixmaterial in Emitterschicht 2 verwendet wird, ist bevorzugt ein Material, dessen LUMO (lowest unoccupied molecular orbital) im Bereich von -2.3 eV bis -3.1 eV liegt, bevorzugt im Bereich von -2.6 eV bis -2.9 eV. Dabei wird das LUMO durch quantenchemische Rechnung bestimmt, wie hinten im Beispielteil ausführlich allgemein beschrieben.

Die Emitterschicht 2 kann auch eine Mischung aus einem elektronenleitenden und mindestens einem weiteren Matrixmaterial enthalten. Wenn die Emitterschicht außer dem elektronenleitenden Matrixmaterial noch ein oder mehrere weitere Matrixmaterialien enthält, dann gilt für das weitere Matrixmaterial bzw. die weiteren Matrixmaterialien, dass das LUMO bevorzugt größer dem LUMO des elektronenleitenden Matrixmaterials + 0.2 eV ist.

Die Triplettenergie T₁ des elektronenleitenden Matrixmaterials ist bevorzugt ≥ 2.5 eV, besonders bevorzugt ≥ 2.7 eV. Dabei sollte die Triplettenergie T₁ größer sein als die des phosphoreszierenden Emitters.

Das Triplettenergie T₁ eines Moleküls ist definiert als die Energiedifferenz zwischen der Energie des Grundzustands eines Moleküls und der Energie des niedrigsten Triplettzustands dieses Moleküls. Dabei wir die Triplettenergie T₁ durch quantenchemische Methoden bestimmt, wie hinten im Beispielteil ausführlich allgemein beschrieben.

In einer bevorzugten Ausführungsform der Erfindung liegt der kürzerwellig phosphoreszierende Emitter in Emitterschicht 1 in einer Konzentration von 3 bis 25 Vol.-%, besonders bevorzugt in einer Konzentration von 5 bis 15 Vol.-% vor. Weiterhin bevorzugt liegt der längerwellig phosphoreszierende Emitter in Emitterschicht 1 in einer Konzentration von 2 bis 15 Vol.-%, besonders bevorzugt in einer Konzentration von 3 bis 10 Vol.-% vor.

Dabei wird das Konzentrationsverhältnis der beiden phosphoreszierenden Emitter in Emitterschicht 1 bevorzugt so gewählt, dass mindestens 90 % der Gesamtemission aus dem längerwellig phosphoreszierenden Emitter stammen. Dies kann dadurch bestimmt werden, dass man eine Vergleichs-OLED baut, bei der der Dotand in der Emitterschicht 2 weggelassen wird, so dass nur Emitterschicht 1 leuchtet. Durch einen quantitativen Abgleich zwischen dem Elektrolumineszenzspektrum dieser Vergleichs-OLED mit den Photolumineszenzspektren der beiden verwendeten Emitter kann abgeschätzt werden, welcher Emitter wie stark zur Emission beiträgt.

In einer weiteren bevorzugten Ausführungsform der Erfindung liegt der phosphoreszierende Emitter in Emitterschicht 2 in einer Konzentration von 2 bis 20 Vol.-% vor, besonders bevorzugt in einer Konzentration von 5 bis 15 Vol.-%. In einer bevorzugten Ausführungsform der Erfindung enthält die Emitterschicht 2 genau einen phosphoreszierenden Emitter.

In einer weiteren bevorzugten Ausführungsform der Erfindung liegt die Schichtdicke der Emitterschicht 1 zwischen 5 und 50 nm, besonders bevorzugt zwischen 10 und 30 nm.

In nochmals einer weiteren bevorzugten Ausführungsform der Erfindung liegt die Schichtdicke der Emitterschicht 2 zwischen 5 und 50 nm, besonders bevorzugt zwischen 10 und 30 nm.

Die oben sowie nachfolgend beschriebenen Ausführungsformen der Erfindung können beliebig miteinander kombiniert werden. Bevorzugt werden die oben sowie nachfolgend als bevorzugt genannten Ausführungsformen miteinander kombiniert.

Das elektronenleitende Matrixmaterial in der Emitterschicht 2 ist nicht weiter eingeschränkt, und generell eignen sich hierfür verschiedene Stoffklassen. Geeignete und bevorzugte elektronenleitende Matrixmaterialien sind ausgewählt aus der Gruppe bestehend aus Triazinen, Pyrimidinen und aromatischen Ketonen.

In einer bevorzugten Ausführungsform der Erfindung ist das elektronenleitende Matrixmaterial ein Triazinderivat oder ein Pyrimidinderivat, welches mit mindestens einem aromatischen oder heteroaromatischen Ringsystem, bevorzugt mit mindestens zwei aromatischen oder heteroaromatischen Ringsystemen und besonders bevorzugt mit drei aromatischen oder heteroaromatischen Ringsystemen substituiert ist. Geeignete Triazinderivate, die als elektronenleitendes Material verwendet werden können, sind Verbindungen der folgenden Formel (1) oder (2), und geeignete Pyrimidinderivate sind die Verbindungen der folgenden Formeln (3), (4) oder (5), 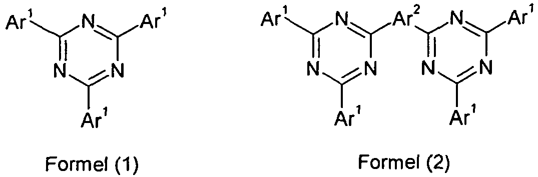 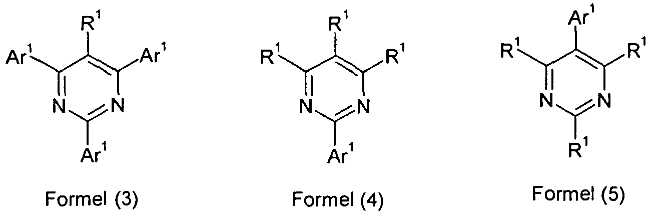 wobei für die verwendeten Symbole gilt:
- Ar¹: ist gleich oder verschieden bei jedem Auftreten ein monovalentes aromatisches oder heteroaromatisches Ringsystem mit 5 bis 60 aromatischen Ringatomen, welches jeweils mit einem oder mehreren Resten R¹ substituiert sein kann;
- Ar²: ist ein bivalentes aromatisches oder heteroaromatisches Ringsystem mit 5 bis 60 aromatischen Ringatomen, welches mit einem oder mehreren Resten R¹ substituiert sein kann;
- R¹: ist bei jedem Auftreten gleich oder verschieden H, D, F, Cl, Br, I, CHO, C(=O)Ar³, P(=O)(Ar³)₂, S(=O)Ar³, S(=O)₂Ar³, CR²=CR²Ar³, CN, NO₂, Si(R²)₃, B(OR²)₂, B(R²)₂, B(N(R²)₂)₂, OSO₂R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Kombination dieser Systeme; dabei können zwei oder mehrere benachbarte Substituenten R¹ auch miteinander ein mono- oder poly-cyclisches, aliphatisches oder aromatisches Ringsystem bilden;
- Ar³: ist bei jedem Auftreten gleich oder verschieden ein aromatisches oder heteroaromatisches Ringsystem mit 5 bis 40 aromatischen Ringatomen, das mit einem oder mehreren Resten R² substituiert sein kann;
- R²: ist bei jedem Auftreten gleich oder verschieden H, D, CN oder ein aliphatischer, aromatischer und/oder heteroaromatischer Kohlenwasserstoffrest mit 1 bis 20 C-Atomen, in dem auch H-Atome durch D oder F ersetzt sein können; dabei können zwei oder mehrere benachbarte Substituenten R² auch miteinander ein mono- oder polycyclisches, aliphatisches oder aromatisches Ringsystem bilden.

Eine Arylgruppe im Sinne dieser Erfindung enthält mindestens 6 C-Atome; eine Heteroarylgruppe im Sinne dieser Erfindung enthält mindestens 2 C-Atome und mindestens 1 Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Pyren, Chinolin, Isochinolin, etc., verstanden.

Ein aromatisches Ringsystem im Sinne dieser Erfindung enthält mindestens 6 C-Atome im Ringsystem. Ein heteroaromatisches Ringsystem im Sinne dieser Erfindung enthält mindestens 2 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine kurze, nicht-aromatische Einheit, wie z. B. ein C-, N- oder O-Atom oder eine Carbonylgruppe, verbunden sein können. So sollen beispielsweise auch Systeme wie 9,9'-Spirobifluoren, 9,9-Diarylfluoren, Triarylamin, Diarylether, Diarylmethan, Stilben, Benzophenon, etc. als aromatische Ringsysteme im Sinne dieser Erfindung verstanden werden. Ebenso werden unter einem aromatischen bzw. heteroaromatischen Ringsystem Systeme verstanden, in denen mehrere Aryl- bzw. Heteroarylgruppen durch Einfachbindungen miteinander verknüpft sind, beispielsweise Biphenyl, Terphenyl oder Bipyridin.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl und 2,2,2-Trifluorethyl verstanden. Unter einer unter einer C₂- bis C₄₀-Alkenylgruppe werden bevorzugt Ethenyl, Propenyl, Butenyl, Pentenyl, Cyclopentenyl, Hexenyl, Cyclohexenyl, Heptenyl, Cycloheptenyl, Octenyl und Cyclooctenyl verstanden. Unter einer unter einer C₂- bis C₄₀-Alkinylgruppe werden bevorzugt Ethinyl, Propinyl, Butinyl, Pentinyl, Hexinyl, Heptinyl und Octinyl verstanden. Unter einer C₁- bis C₄₀-Alkoxy-gruppe werden besonders bevorzugt Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Benzanthracen, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Benzofluoren, Dibenzofluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt ist in Verbindungen der Formel (1) bis (5) mindestens eine Gruppe Ar¹ gewählt aus den Gruppen der folgenden Formeln (6) bis (13), und die anderen Gruppen Ar¹ haben die oben angegebene Bedeutung, 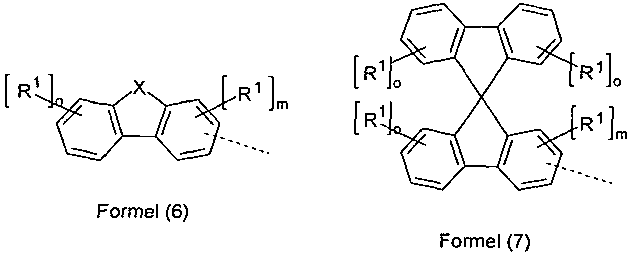 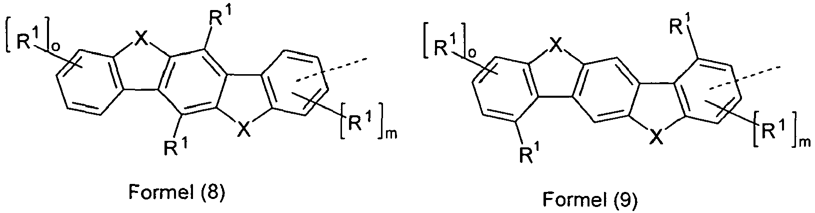 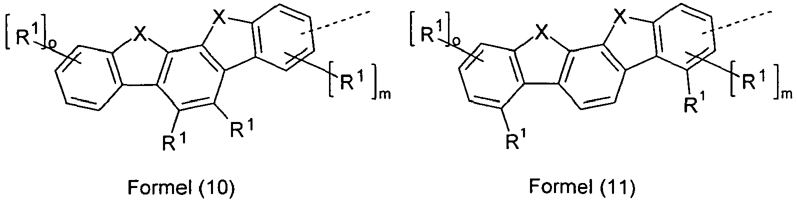 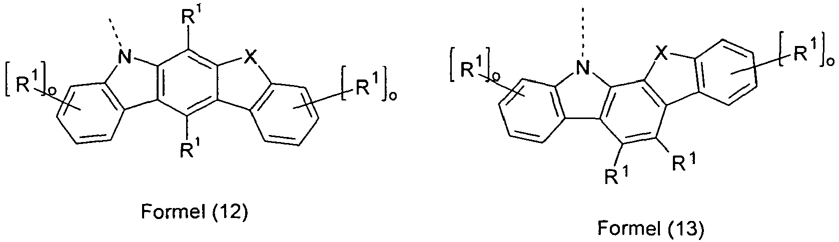 wobei R¹ dieselbe Bedeutung hat, wie oben beschrieben, die gestrichelte Bindung die Verknüpfung mit der Triazineinheit darstellt und weiterhin gilt:
- X: ist gleich oder verschieden bei jedem Auftreten eine bivalente Brücke, ausgewählt aus B(R¹), C(R¹)₂, Si(R¹)₂, C=O, C=NR¹, C=C(R¹)₂, O, S, S=O, SO₂, N(R¹), P(R¹) und P(=O)R¹;
- m: ist bei jedem Auftreten gleich oder verschieden 0, 1, 2 oder 3;
- o: ist bei jedem Auftreten gleich oder verschieden 0, 1, 2, 3 oder 4.

Bevorzugt steht X gleich oder verschieden bei jedem Auftreten für NR¹ oder C(R¹)₂.

Besonders bevorzugte Gruppen Ar¹ sind gewählt aus den Gruppen der folgenden Formeln (6a) bis (13a), 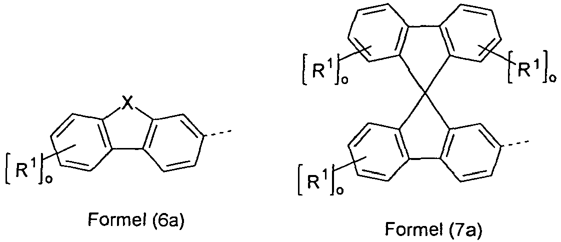 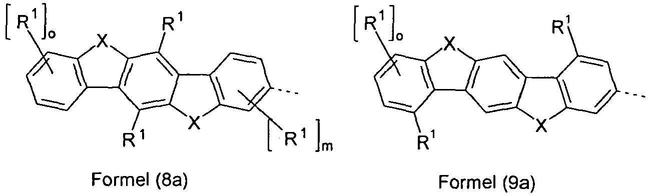 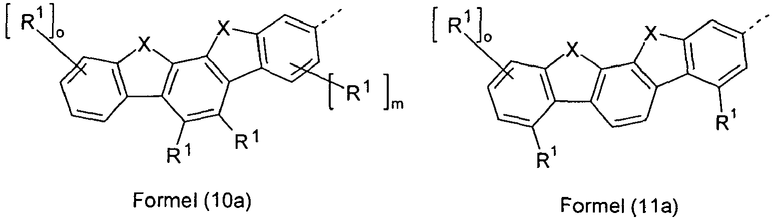 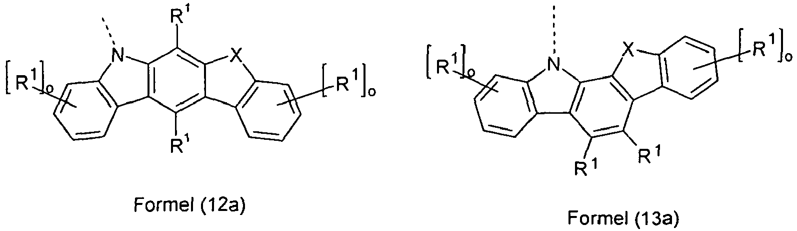 wobei die verwendeten Symbole und Indizes dieselbe Bedeutung haben, wie oben beschrieben. Dabei ist X bevorzugt gleich oder verschieden gewählt aus C(R¹)₂, N(R¹), O und S, besonders bevorzugt C(R¹)₂ oder N(R¹).

Bevorzugte Verbindungen der Formel (1) und (3) bis (5) weisen eine oder zwei Gruppen der oben genannten Formel (6) bis (13) auf, insbesondere eine Gruppe, und weisen zwei oder eine Gruppen aus, welche ausgewählt sind aus Phenyl, 1-Naphthyl, 2-Naphthyl, ortho-, meta- oder para-Biphenyl, welches jeweils durch einen oder mehrere Reste R¹ substituiert sein kann.

Bevorzugte Gruppen Ar² in Verbindungen der Formel (2) sind gewählt aus den Gruppen der folgenden Formeln (14) bis (20), 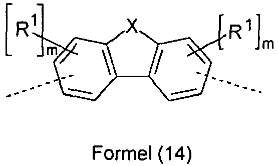 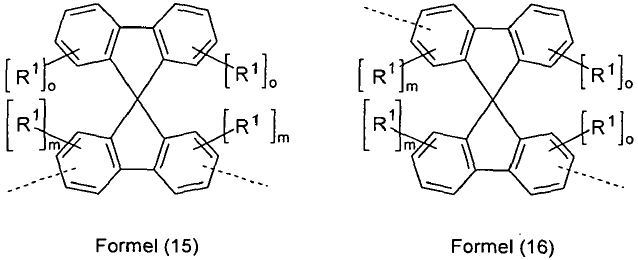 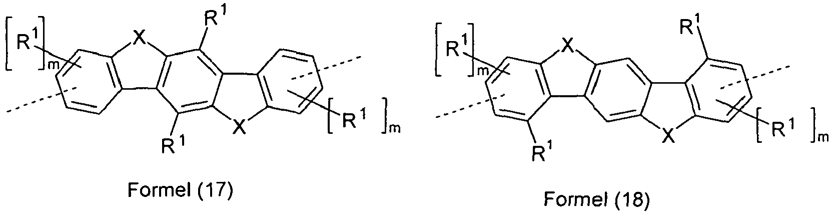 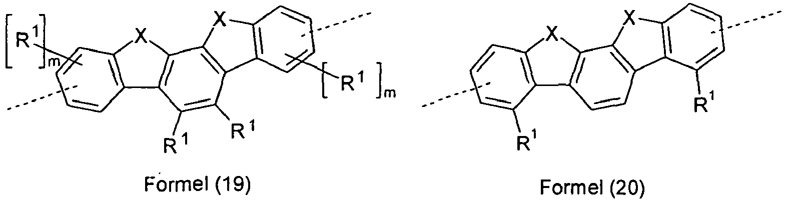 wobei die verwendeten Symbole und Indizes dieselbe Bedeutung haben, wie oben beschrieben und die gestrichelte Bindung die Verknüpfung mit den beiden Triazineinheiten darstellt.

Besonders bevorzugte Gruppen Ar² sind gewählt aus den Gruppen der folgenden Formeln (14a) bis (20a), 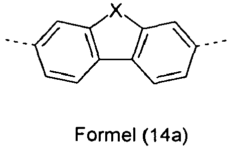 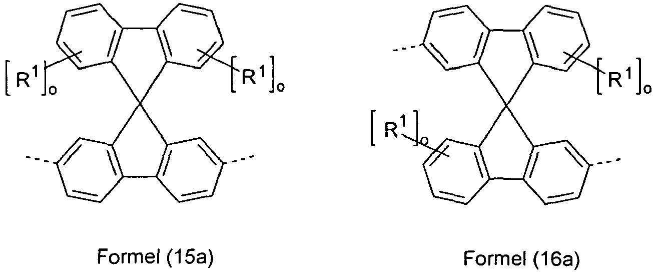 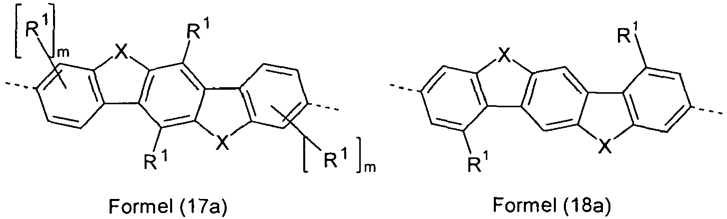 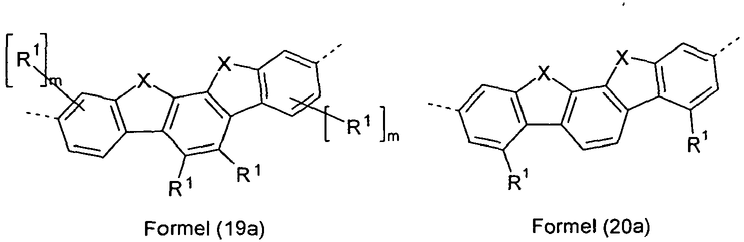 wobei die verwendeten Symbole und Indizes dieselbe Bedeutung haben, wie oben beschrieben. Dabei ist X bevorzugt gleich oder verschieden gewählt aus C(R¹)₂, N(R¹), O und S, besonders bevorzugt C(R¹)₂ oder N(R¹).

Bevorzugt sind weiterhin Verbindungen der oben aufgeführten Formel (2), in der die Gruppe Ar² aus den oben aufgeführten Formeln (14) bis (20) ausgewählt ist und Ar¹ gleich oder verschieden bei jedem Auftreten ausgewählt ist aus den oben aufgeführten Formeln (6) bis (13) oder Phenyl, 1- oder 2-Naphthyl, ortho-, meta- oder para-Biphenyl, welche durch einen oder mehrere Reste R¹ substituiert sein können, jedoch bevorzugt unsubstituiert sind.

Beispiele für geeignete Triazinderivate sind die im Folgenden abgebildeten Strukturen 1 bis 150. Ganz analog eignen sich Pyrimidinderivate, die statt den in den Strukturen abgebildeten Triazingruppen Pyrimidingruppen enthalten.

| | | |
|---|---|---|
| 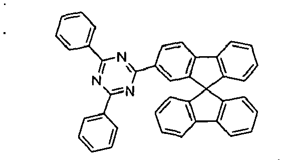 | 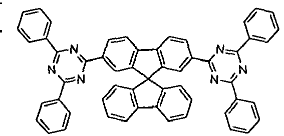 | 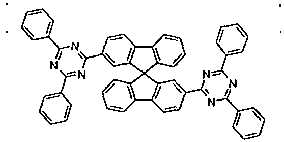 |
| 1 | 2 | 3 |
| 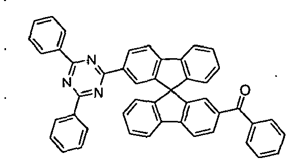 | 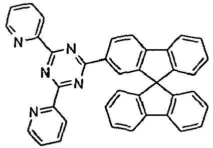 | 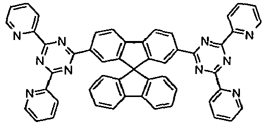 |
| 4 | 5 | 6 |
| 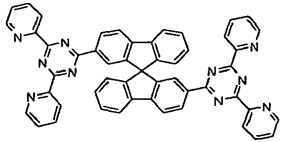 | 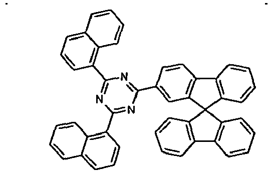 | 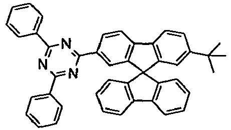 |
| 7 | 8 | 9 |
| 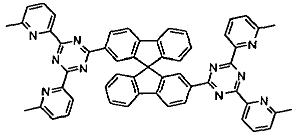 | 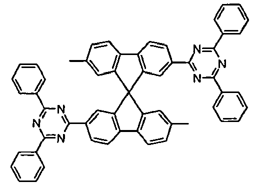 | 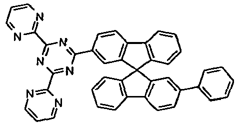 |
| 10 | 11 | 12 |
| 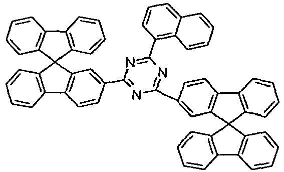 | 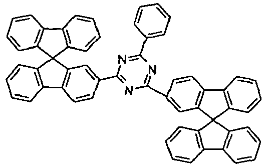 | 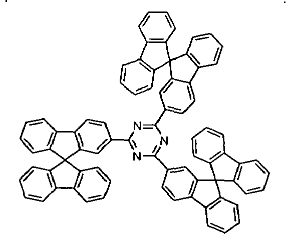 |
| 13 | 14 | 15 |
| 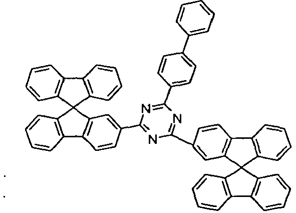 | 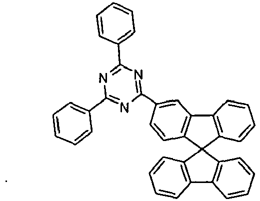 | 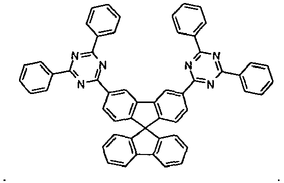 |
| 16 | 17 | 18 |
| 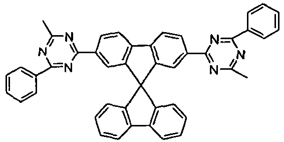 | 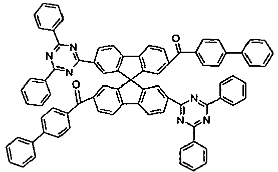 | 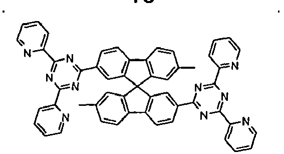 |
| 19 | 20 | 21 |
| 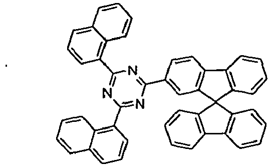 | 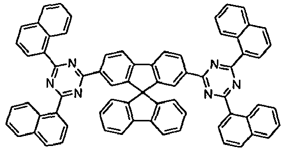 | 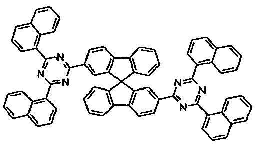 |
| 22 | 23 | 24 |
| 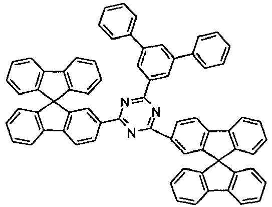 | 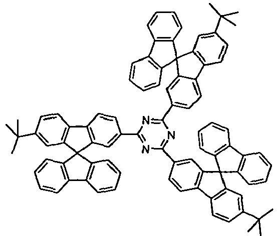 | 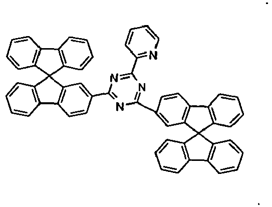 |
| 25 | 26 | 27 |
| 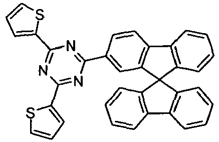 | 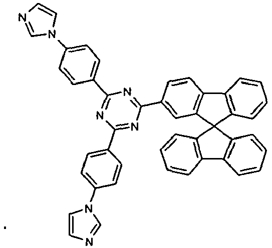 | 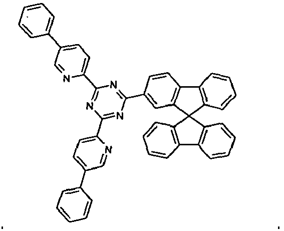 |
| 28 | 29 | 30 |
| 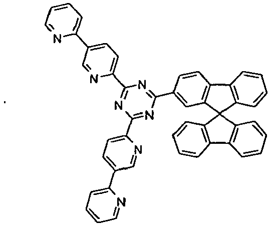 | 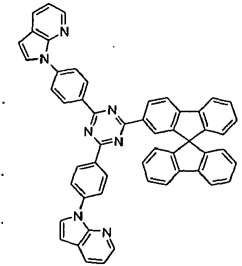 | 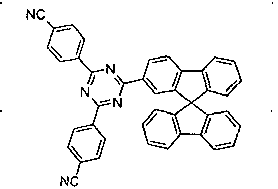 |
| 31 | 32 | 33 |
| 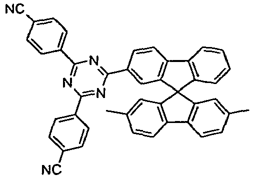 | 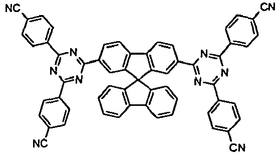 | 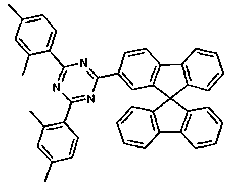 |
| 34 | 35 | 36 |
| 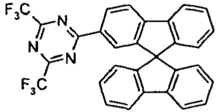 | 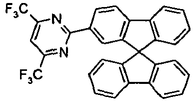 | 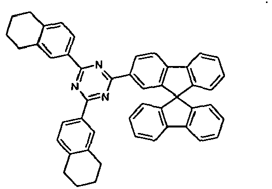 |
| 37 | 38 | 39 |
| 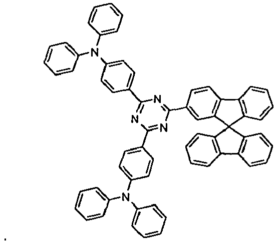 | 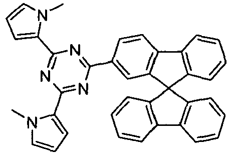 | 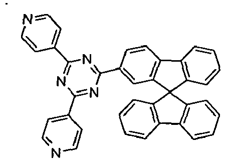 |
| 40 | 41 | 42 |
| 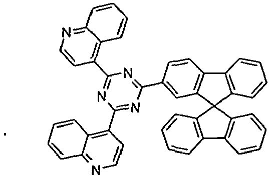 | 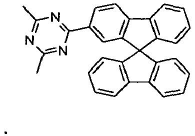 | 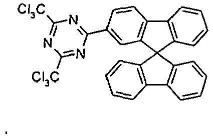 |
| 43 | 44 | 45 |
| 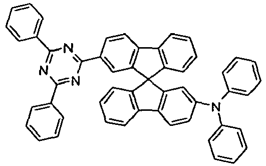 | 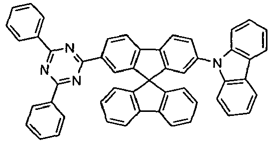 | 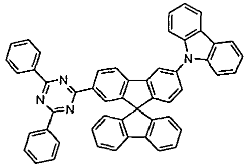 |
| 46 | 47 | 48 |
| 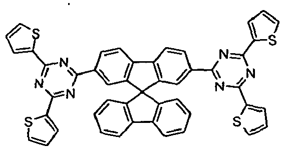 | 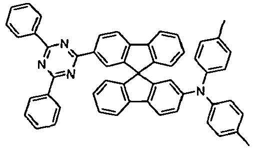 | 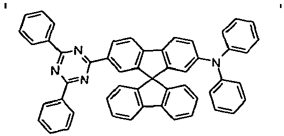 |
| 49 | 50 | 51 |
| 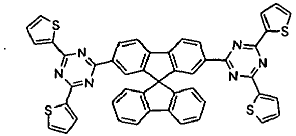 | 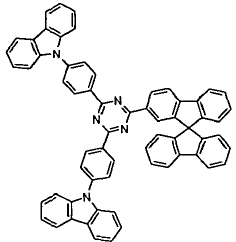 | 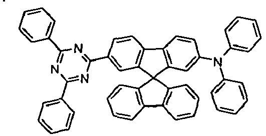 |
| 52 | 53 | 54 |
| 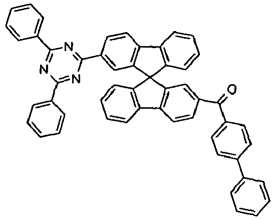 | 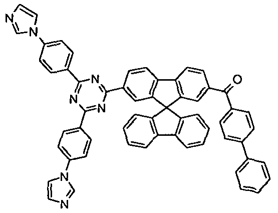 | 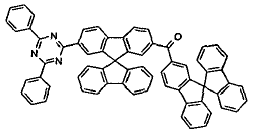 |
| 55 | 56 | 57 |
| 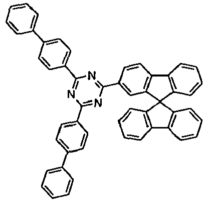 | 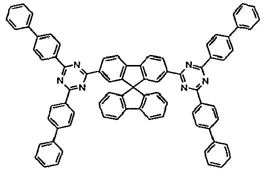 | 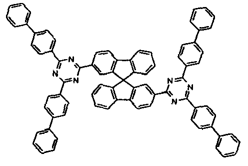 |
| 58 | 59 | 60 |
| 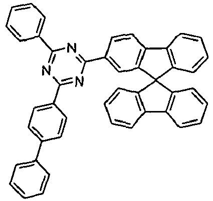 | 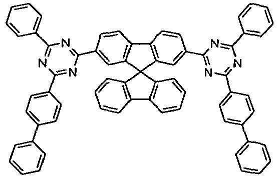 | 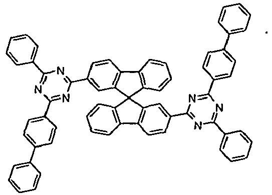 |
| 61 | 62 | 63 |
| 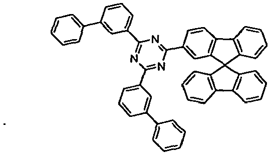 | 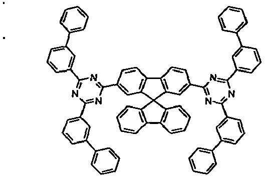 | 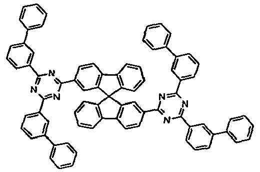 |
| 64 | 65 | 66 |
| 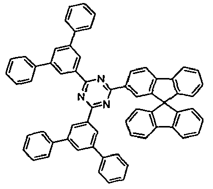 | 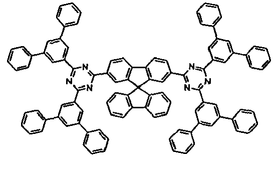 | 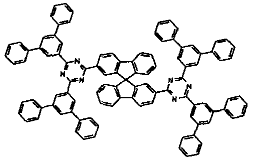 |
| 67 | 68 | 69 |
| 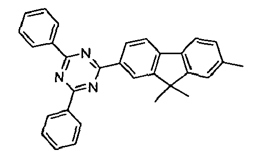 | 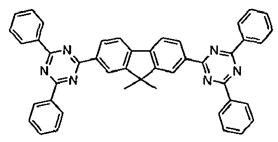 | 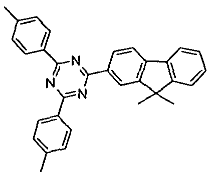 |
| 70 | 71 | 72 |
| 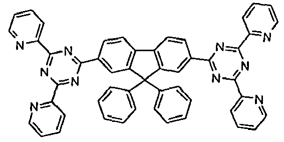 | 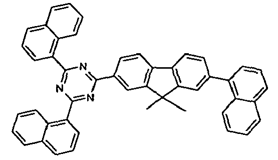 | 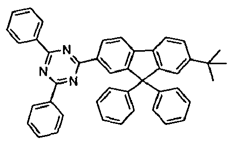 |
| 73 | 74 | 75 |
| 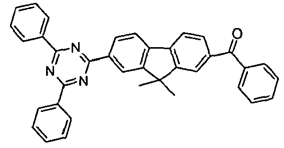 | 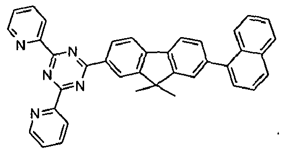 | 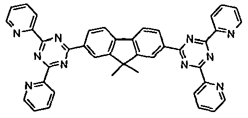 |
| 76 | 77 | 78 |
| 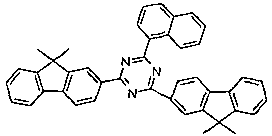 | 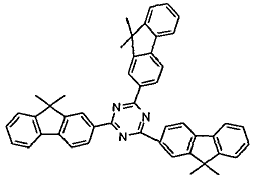 | 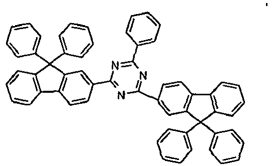 |
| 79 | 80 | 81 |
| 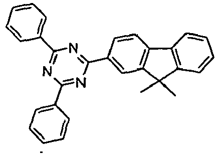 | 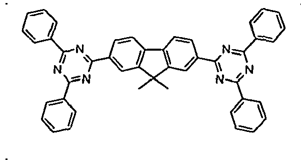 | 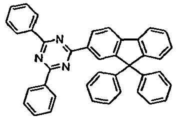 |
| 82 | 83 | 84 |
| 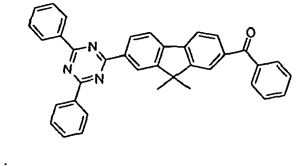 | 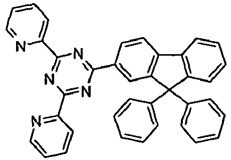 | 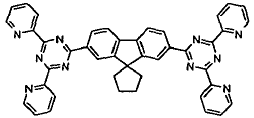 |
| 85 | 86 | 87 |
| 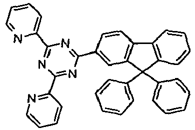 | 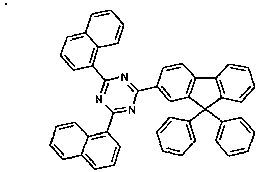 | 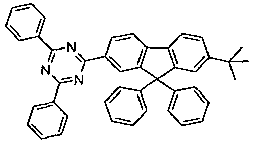 |
| 88 | 89 | 90 |
| 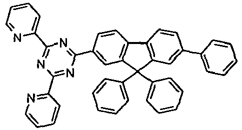 | 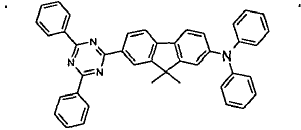 | 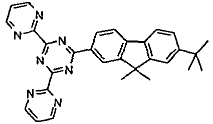 |
| 91 | 92 | 93 |
| 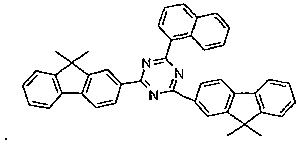 | 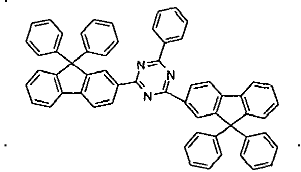 | 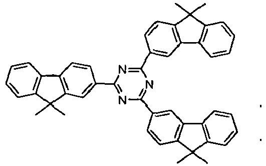 |
| 94 | 95 | 96 |
| 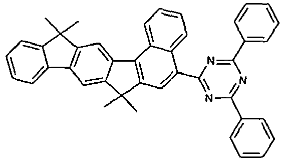 | 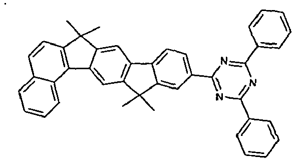 | 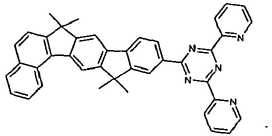 |
| 97 | 98 | 99 |
| 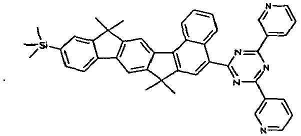 | 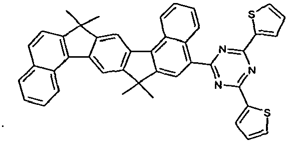 | 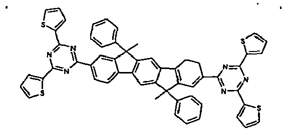 |
| 100 | 101 | 102 |
| 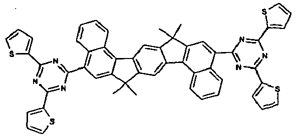 | 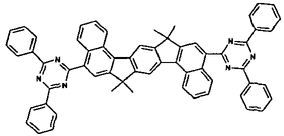 | 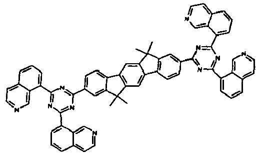 |
| 103 | 104 | 105 |
| 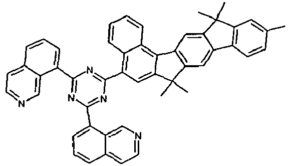 | 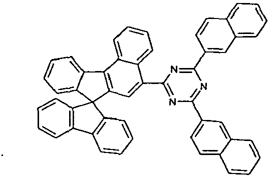 | 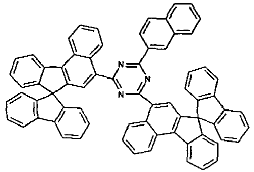 |
| 106 | 107 | 108 |
| 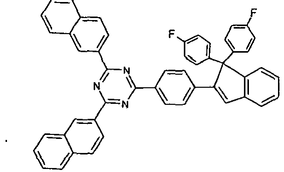 | 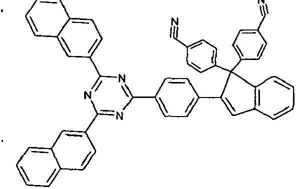 | 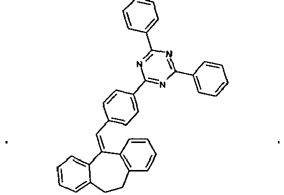 |
| 109 | 110 | 111 |
| 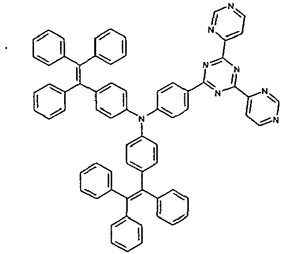 | 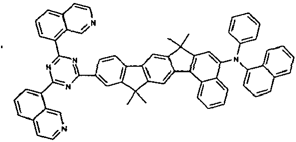 | 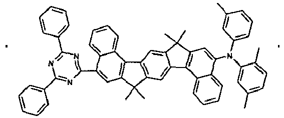 |
| 112 | 113 | 114 |
| 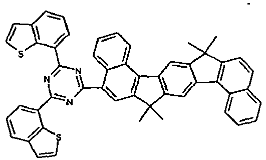 | 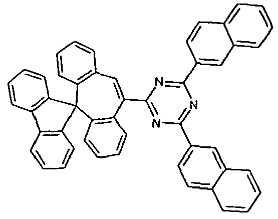 | 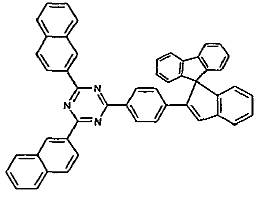 |
| 115 | 116 | 117 |
| 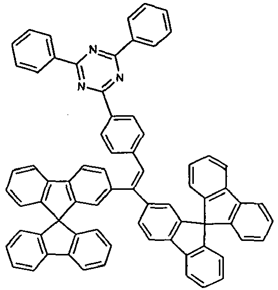 | 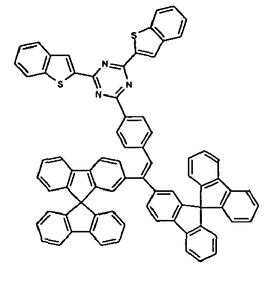 | 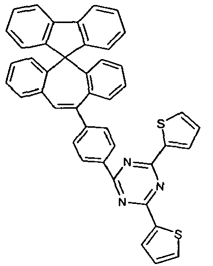 |
| 118 | 119 | 120 |
| 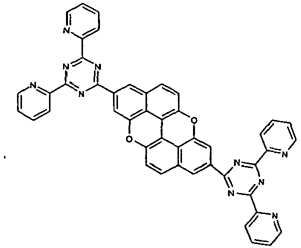 | 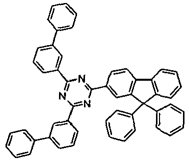 | 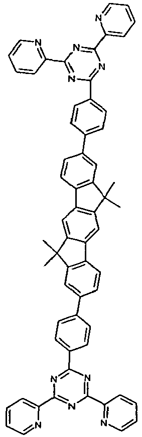 |
| 121 | 122 | 123 |
| 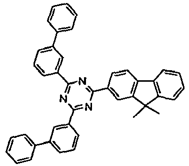 | 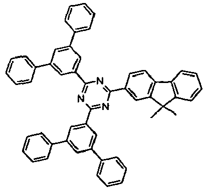 | 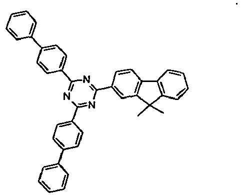 |
| 124 | 125 | 126 |
| 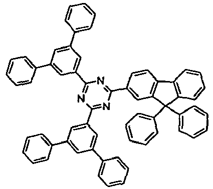 | 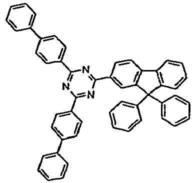 | 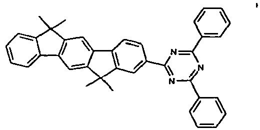 |
| 127 | 128 | 129 |
| 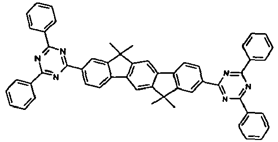 | 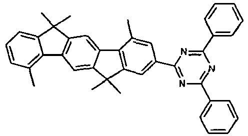 | 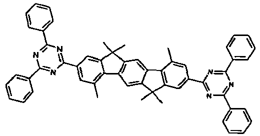 |
| 130 | 131 | 132 |
| 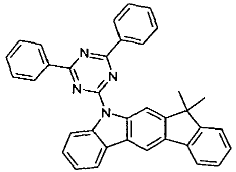 | 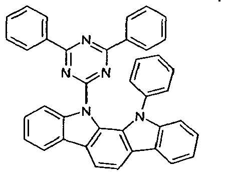 | 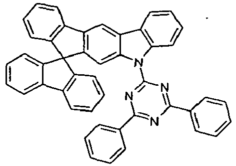 |
| 133 | 134 | 135 |
| 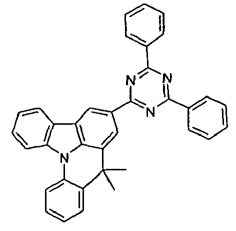 | 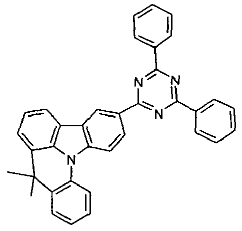 | 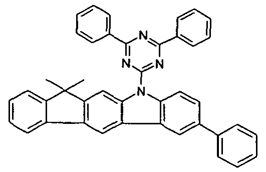 |
| 136 | 137 | 138 |
| 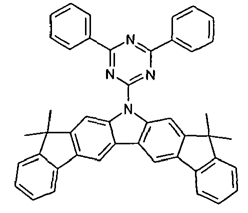 | 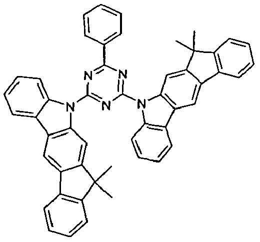 | 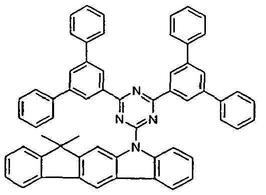 |
| 139 | 140 | 141 |
| 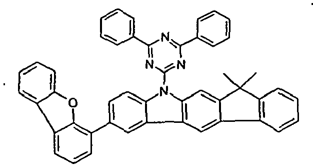 | 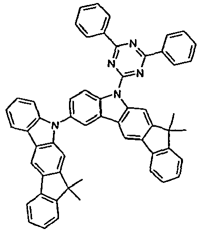 | 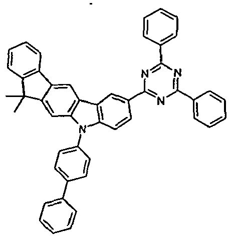 |
| 142 | 143 | 144 |
| 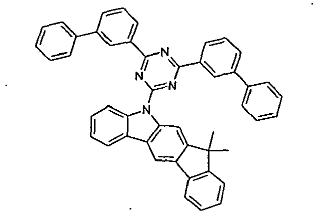 | 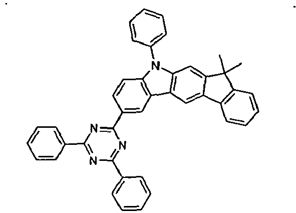 | 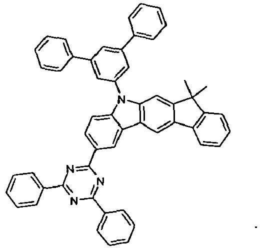 |
| 145 | 146 | 147 |
| 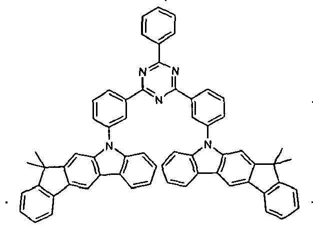 | 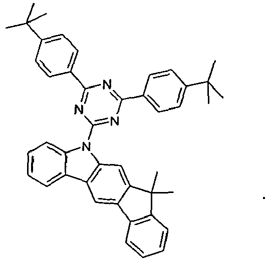 | 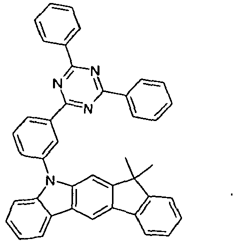 |
| 148 | 149 | 150 |

Ebenso eignen sich Derivate der oben genannten Verbindungen, die statt der Triazingruppe eine Pyrazingruppe enthalten, wobei diese Gruppen ebenfalls substituiert sein können.

In einer weiteren bevorzugten Ausführungsform der Erfindung ist das elektronenleitende Matrixmaterial ein aromatisches Keton.

Unter einem aromatischen Keton im Sinne dieser Anmeldung wird eine Carbonylgruppe verstanden, an die zwei Aryl- oder Heteroarylgruppen bzw. aromatische oder heteroaromatische Ringsysteme direkt gebunden sind.

In einer bevorzugten Ausführungsform der Erfindung ist das aromatische Keton eine Verbindung der folgenden Formel (21), 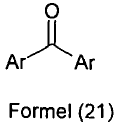 wobei R¹ die oben genannte Bedeutung aufweist und Ar bei jedem Auftreten gleich oder verschieden ein aromatisches oder heteroaromatisches Ringsystem mit 5 bis 60 aromatischen Ringatomen darstellt, welches jeweils mit einer oder mehreren Gruppen R¹ substituiert sein kann.

Geeignete Verbindungen gemäß Formel (21) sind insbesondere die in WO 2004/093207 und WO 2010/006680 offenbarten Ketone. Diese sind via Zitat Bestandteil der vorliegenden Erfindung.

Aus der Definition der Verbindung gemäß Formel (21) geht hervor, dass diese nicht nur eine Carbonylgruppe enthalten muss, sondern auch mehrere Carbonylgruppen enthalten kann.

Bevorzugt ist die Gruppe Ar in Verbindungen gemäß Formel (21) ein aromatisches Ringsystem mit 6 bis 40 aromatischen Ringatomen, d. h. sie enthält keine Heteroarylgruppen. Wie oben definiert, muss das aromatische Ringsystem nicht notwendigerweise nur aromatische Gruppen aufweisen, sondern es können auch zwei Arylgruppen durch eine nicht-aromatische Gruppe, beispielsweise durch eine weitere Carbonylgruppe unterbrochen sein.

In einer weiteren bevorzugten Ausführungsform der Erfindung weist die Gruppe Ar nicht mehr als zwei kondensierte Ringe auf. Sie ist also bevorzugt nur aus Phenyl- und/oder Naphthylgruppen, besonders bevorzugt nur aus Phenylgruppen, aufgebaut, enthält aber keine größeren kondensierten Aromaten, wie beispielsweise Anthracen.

Bevorzugte Gruppen Ar, die an die Carbonylgruppe gebunden sind, sind Phenyl, 2-, 3- oder 4-Tolyl, 3- oder 4-o-Xylyl, 2- oder 4-m-Xylyl, 2-p-Xylyl, o-, m- oder p-tert-Butylphenyl, o-, m- oder p-Fluorphenyl, Benzophenon, 1-, 2- oder 3-Phenylmethanon, 2-, 3- oder 4-Biphenyl, 2-, 3- oder 4-o-Terphenyl, 2-, 3- oder 4-m-Terphenyl, 2-, 3- oder 4-p-Terphenyl, 2'-p-Terphenyl, 2'-, 4'- oder 5'-m-Terphenyl, 3'- oder 4'-o-Terphenyl, p-, m,p-, o,p-, m,m-, o,m- oder o,o-Quaterphenyl, Quinquephenyl, Sexiphenyl, 1-, 2-, 3- oder 4-Fluorenyl, 2-, 3- oder 4-Spiro-9,9'-bifluorenyl, 1-, 2-, 3- oder 4-(9,10-Dihydro)phenanthrenyl, 1- oder 2-Naphthyl, 2-, 3-, 4-, 5-, 6-, 7- oder 8-Chinolinyl, 1-, 3-, 4-, 5-, 6-, 7- oder 8-iso-Chinolinyl, 1- oder 2-(4-Methylnaphthyl), 1- oder 2-(4-Phenylnaphthyl), 1-oder 2-(4-naphthyl-naphthyl), 1-, 2- oder 3-(4-naphthyl-phenyl), 2-, 3- oder 4-Pyridyl, 2-, 4- oder 5-Pyrimidinyl, 2- oder 3-Pyrazinyl, 3- oder 4-Pyridanzinyl, 2-(1,3,5-Triazin)yl-, 2-, 3- oder 4-(Phenylpyridyl), 3-, 4-, 5- oder 6-(2,2'-Bipyridyl), 2-, 4-, 5- oder 6-(3,3'-Bipyridyl), 2- oder 3-(4,4'-Bipyridyl) und Kombinationen eines oder mehrerer dieser Reste.

Die Gruppen Ar können durch einen oder mehrere Reste R¹ substituiert sein. Diese Reste R¹ sind bevorzugt gleich oder verschieden bei jedem Auftreten gewählt aus der Gruppe bestehend aus H, D, F, C(=O)Ar³, P(=O)(Ar³)₂, S(=O)Ar³, S(=O)₂Ar³, einer geradkettigen Alkylgruppe mit 1 bis 4 C-Atomen oder einer verzweigten oder cyclischen Alkylgruppe mit 3 bis 5 C-Atomen, die jeweils mit einem oder mehreren Resten R² substituiert sein kann, wobei ein oder mehrere H-Atome durch D oder F ersetzt sein können, oder einem aromatischen Ringsystem mit 6 bis 24 aromatischen Ringatomen, das durch einen oder mehrere Reste R² substituiert sein kann, oder eine Kombination dieser Systeme; dabei können zwei oder mehrere benachbarte Substituenten R¹ auch miteinander ein mono- oder polycyclisches, aliphatisches oder aromatisches Ringsystem bilden. Wenn die organische Elektrolumineszenzvorrichtung aus Lösung aufgebracht wird, sind auch geradkettige, verzweigte oder cyclische Alkylgruppen mit bis zu 10 C-Atomen als Substituenten R¹ bevorzugt. Die Reste R¹ sind besonders bevorzugt gleich oder verschieden bei jedem Auftreten gewählt aus der Gruppe bestehend aus H, C(=O)Ar³ oder einem aromatischen Ringsystem mit 6 bis 24 aromatischen Ringatomen, das durch einen oder mehrere Reste R² substituiert sein kann, bevorzugt aber unsubstituiert ist. In nochmals einer bevorzugten Ausführungsform der Erfindung ist die Gruppe Ar³ gleich oder verschieden bei jedem Auftreten ein aromatisches Ringsystem mit 6 bis 24 aromatischen Ringatomen, das mit einem oder mehreren Resten R² substituiert sein kann. Besonders bevorzugt ist Ar³ gleich oder verschieden bei jedem Auftreten ein aromatisches Ringsystem mit 6 bis 12 aromatischen Ringatomen.

Besonders bevorzugt sind Benzophenon-Derivate, die jeweils an den 3,5,3',5'-Positionen durch ein aromatisches oder heteroaromatisches Ringsystem mit 5 bis 30 aromatischen Ringatomen substituiert sind, welche wiederum durch einen oder mehrere Reste R¹ gemäß der obigen Definition substituiert sein kann. Weiterhin bevorzugt sind Ketone, welche mit mindestens einer Spirobifluorengruppe substituiert sind.

Bevorzugte aromatische Ketone sind daher weiterhin die Verbindungen der folgenden Formel (22) bis (25), 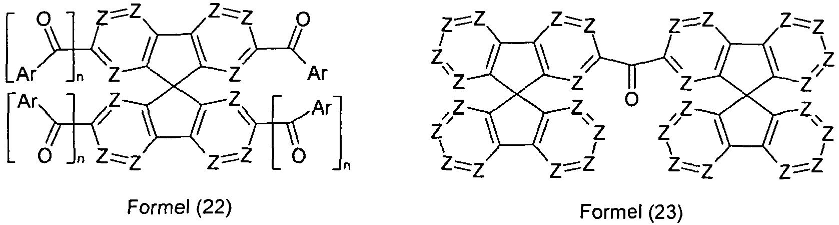 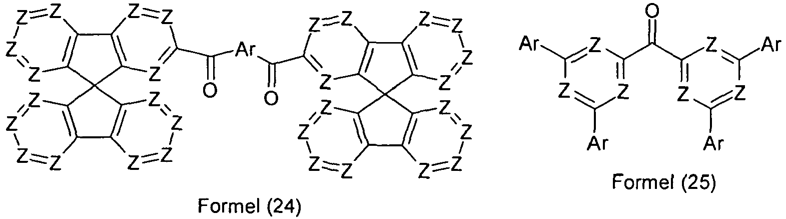 wobei Ar und R¹ dieselbe Bedeutung haben, wie oben für Formel (21) beschrieben, und weiterhin gilt:
Z ist gleich oder verschieden bei jedem Auftreten CR¹ oder N;
n ist gleich oder verschieden bei jedem Auftreten 0 oder 1.

Bevorzugt steht Ar in den Formeln (22), (24) und (25) für ein aromatisches oder heteroaromatisches Ringsystem mit 5 bis 30 aromatischen Ringatomen, welches keine kondensierten Arylgruppen mit mehr als 10 aromatischen Ringatomen aufweist, bevorzugt überhaupt keine kondensierten Arylgruppen, und welches mit einem oder mehreren Resten R¹ substituiert sein kann. Besonders bevorzugt sind die oben als bevorzugt genannten Gruppen Ar. Ebenso besonders bevorzugt sind die oben als bevorzugt genannten Gruppen R¹.

Beispiele für geeignete Verbindungen gemäß Formel (21) bis (25), welche als elektronenleitendes Material in der Zwischenschicht eingesetzt werden können, sind die im Folgenden abgebildeten Verbindungen (1) bis (59).

| | |
|---|---|
| 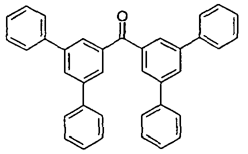 | 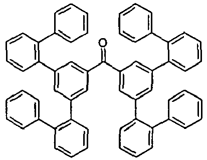 |
| (1) | (2) |
| 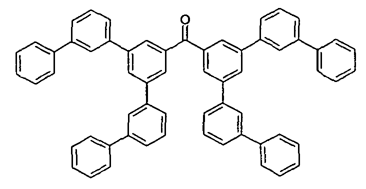 | 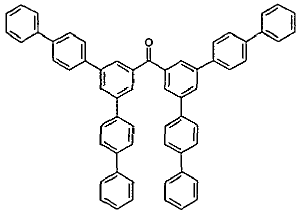 |
| (3) | (4) |
| 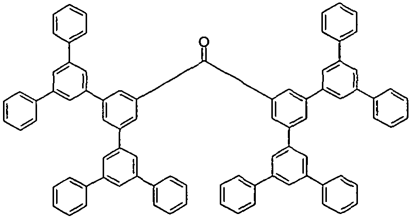 | 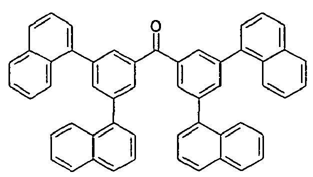 |
| (5) | (6) |
| 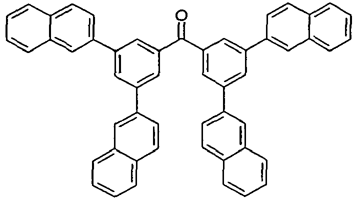 | 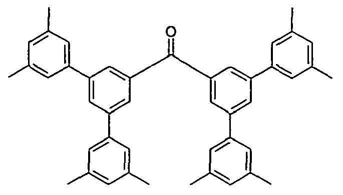 |
| (7) | (8) |
| 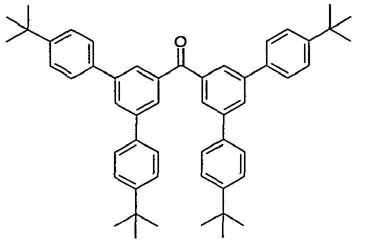 | 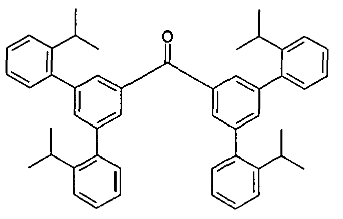 |
| (9) | (10) |
| 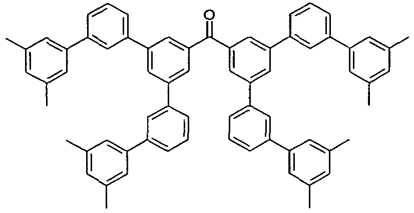 | 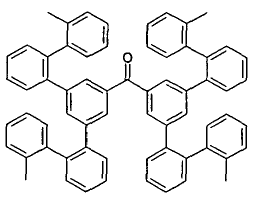 |
| (11) | (12) |
| 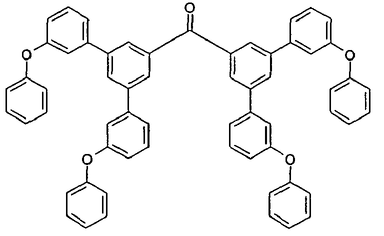 | 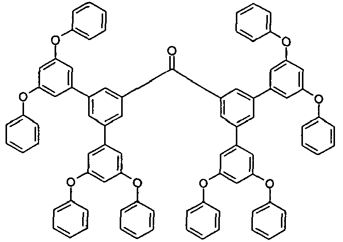 |
| (13) | (14) |
| 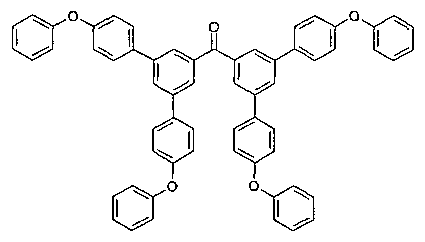 | 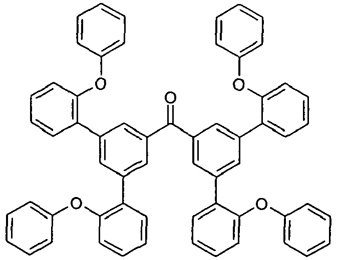 |
| (15) | (16) |
| 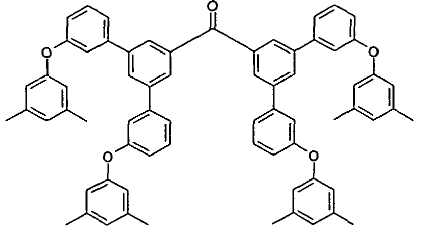 | 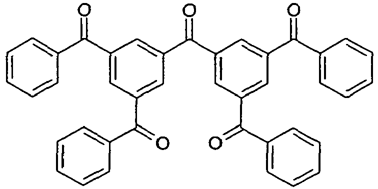 |
| (17) | (18) |
| 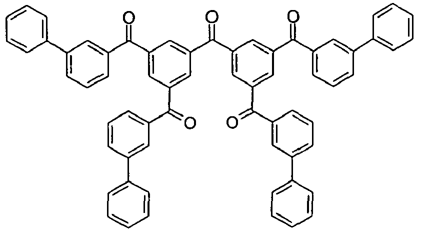 | 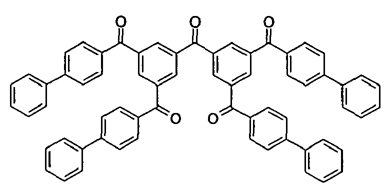 |
| (19) | (20) |
| 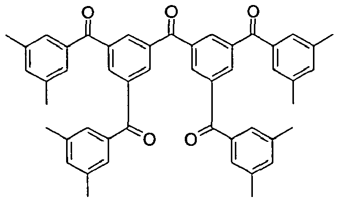 | 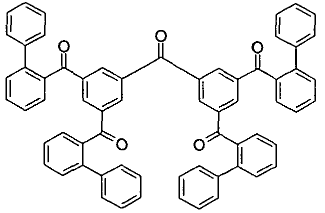 |
| (21) | (22) |
| 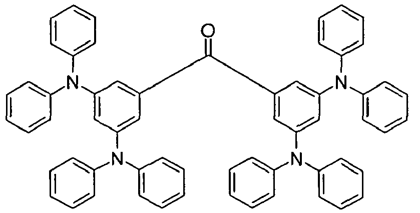 | 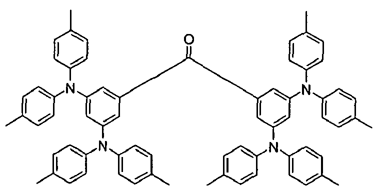 |
| (23) | (24) |
| 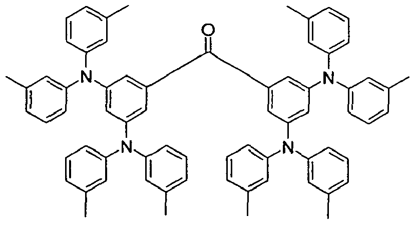 | 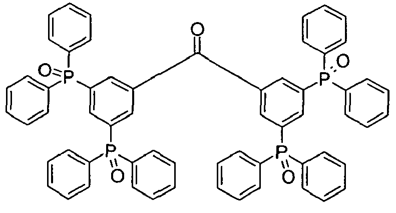 |
| (25) | (26) |
| 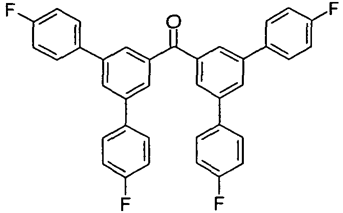 | 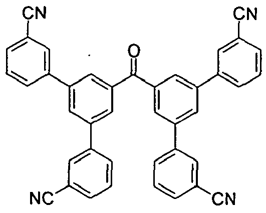 |
| (27) | (28) |
| 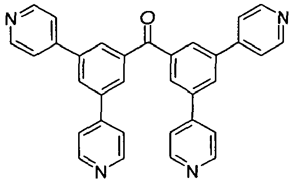 | 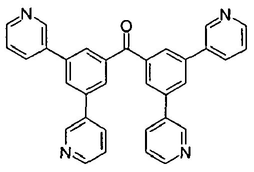 |
| (29) | (30) |
| 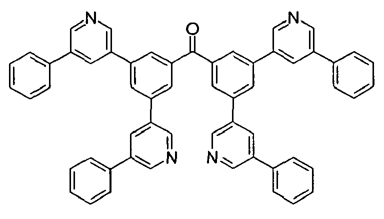 | 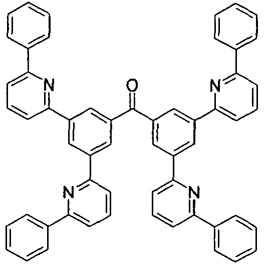 |
| (31) | (32) |
| 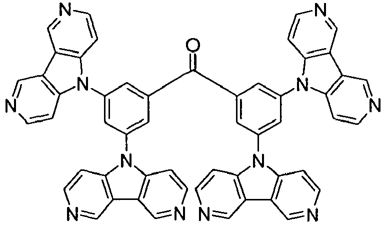 | 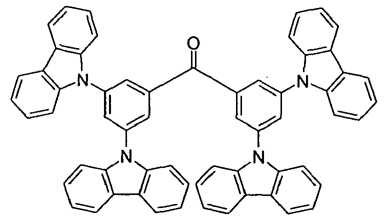 |
| (33) | (34) |
| 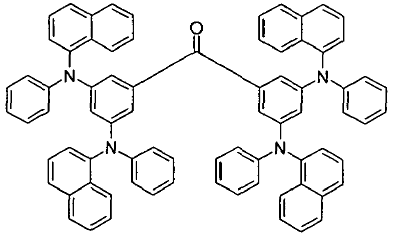 | 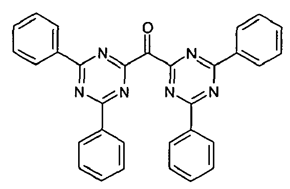 |
| (35) | 36 |
| 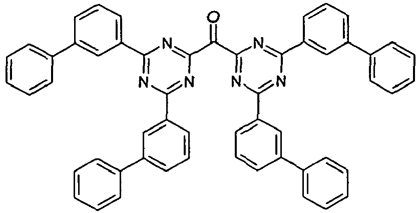 | 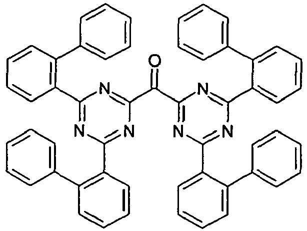 |
| (37) | (38) |
| 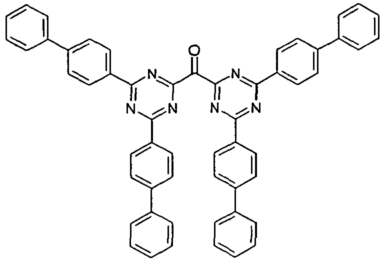 | 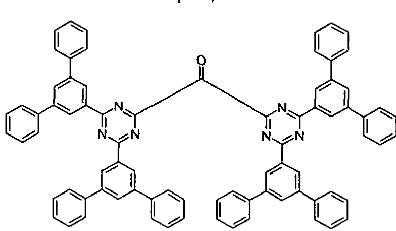 |
| (39) | (40) |
| 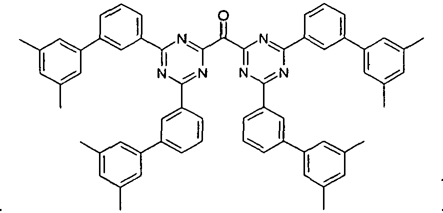 | 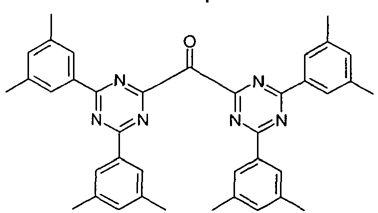 |
| (41) | (42) |
| 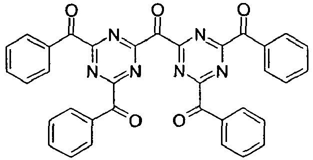 | 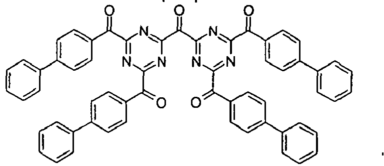 |
| (43) | (44) |
| 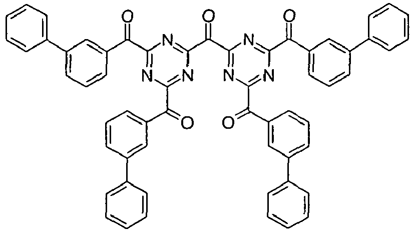 | 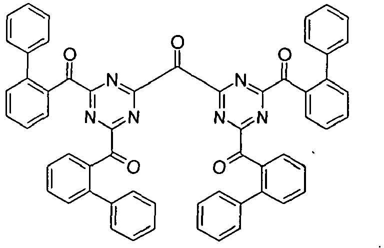 |
| (45) | 46 |
| 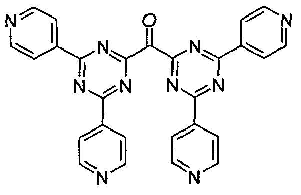 | 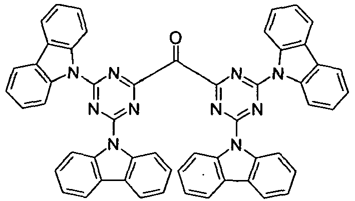 |
| (47) | (48) |
| 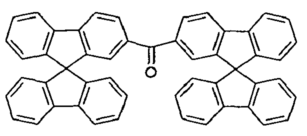 | 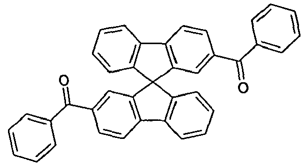 |
| (49) | (50) |
| 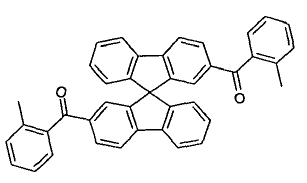 | 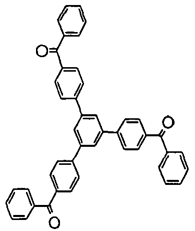 |
| (51) | (52) |
| 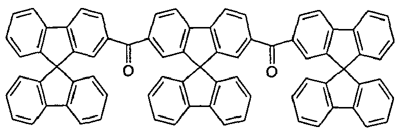 | 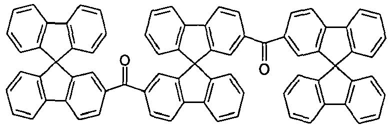 |
| (53) | (54) |
| 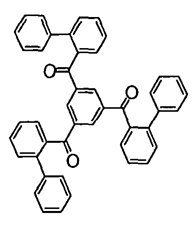 | 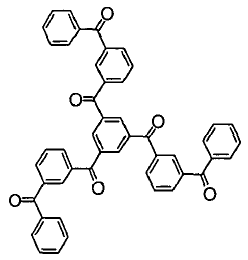 |
| (55) | 56 |
| 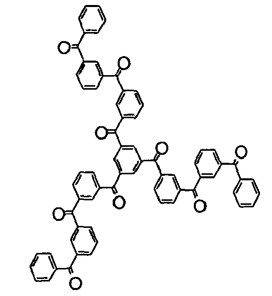 | 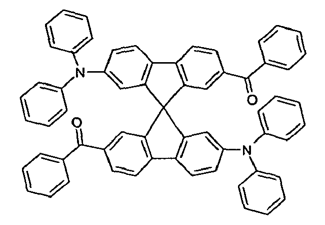 |
| (57) | (58) |
| 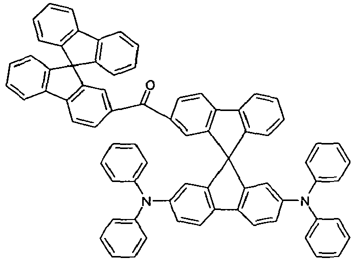 | |
| (59) | |

Das lochleitende Matrixmaterial in der Emitterschicht 1 ist bevorzugt ein aromatisches Monoamin, Diamin, Triamin oder Tetramin, wobei das Amin auch in Form eines Carbazols oder einer anderen verbrückten Verbindung vorliegen kann.

Bevorzugte aromatische Amine sind die Verbindungen der folgenden Formeln (26) bis (32), 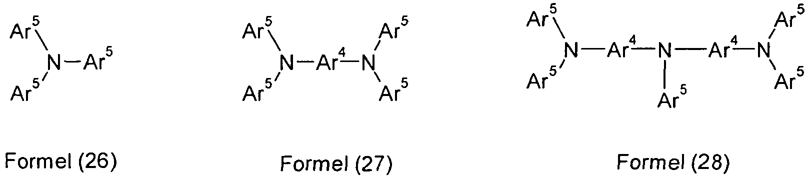 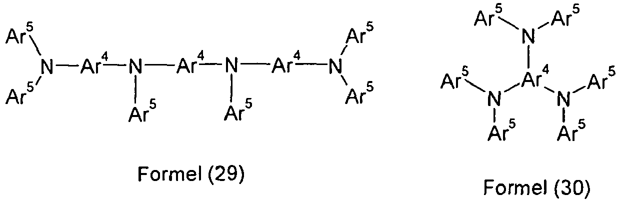 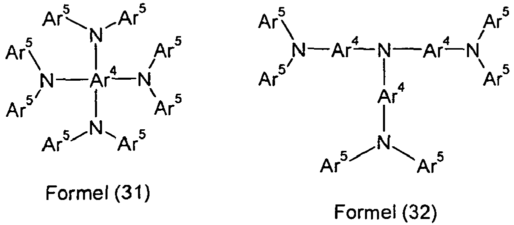 wobei R¹ die oben genannte Bedeutung hat und für die weiteren verwendeten Symbole gilt:
- Ar⁴: ist bei jedem Auftreten gleich oder verschieden ein bivalentes, trivalentes oder tetravalentes aromatisches oder heteroaromatisches Ringsystem mit 5 bis 60 aromatischen Ringatomen, welches durch einen oder mehrere Reste R¹ substituiert sein kann;
- Ar⁵: ist bei jedem Auftreten gleich oder verschieden ein monovalentes aromatisches oder heteroaromatisches Ringsystem mit 5 bis 60 aromatischen Ringatomen, welches durch einen oder mehrere Reste R¹ substituiert sein kann, dabei können zwei Gruppen Ar⁵, welche an dasselbe Stickstoffatom binden, oder eine Gruppe Ar⁴ mit einer Gruppe Ar⁵, welche an dasselbe Stickstoffatom binden, miteinander durch eine Einfachbindung oder eine Brücke, ausgewählt aus der Gruppe bestehend aus B(R¹), C(R¹)₂, Si(R¹)₂, C=O, C=NR¹, C=C(R ¹)₂, O, S, S=O, SO₂, N(R¹), P(R¹) und P(=O)R¹, verknüpft sein.

Wenn zwei Gruppen Ar⁵ oder eine Gruppe Ar⁴ mit einer Gruppe Ar⁵, welche jeweils an dasselbe Stickstoffatom binden, miteinander durch eine Einfachbindung verknüpft sind, entsteht dadurch ein Carbazol.

Ar⁴ ist in den Verbindungen der Formeln (27), (28), (29) und (32) eine bivalente Gruppe und in den Verbindungen der Formel (30) eine trivalente Gruppe und in den Verbindungen der Formel (31) eine tetravalente Gruppe.

Dabei ist es bevorzugt, wenn Ar⁴ und Ar⁵ keine kondensierten Aryl- oder Heteroarylgruppen mit mehr als zwei direkt aneinander kondensierten aromatischen bzw. heteroaromatischen Sechsringen enthalten. Besonders bevorzugt enthalten Ar⁴ und Ar⁵ überhaupt keine direkt aneinander kondensierten aromatischen bzw. heteroaromatischen Sechsringe.

Weitere Verbindungen, die bevorzugt als das lochleitende Matrixmaterial in Emitterschicht 1 eingesetzt werden können, sind die Verbindungen der folgenden Formeln (33) und (34), 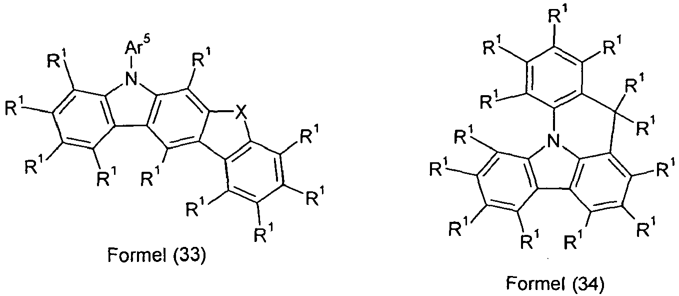 wobei die verwendeten Symbole die oben genannten Bedeutungen aufweisen.

Bevorzugte Ausführungsformen sind die Verbindungen gemäß den folgenden Formeln (33a) und (34a), 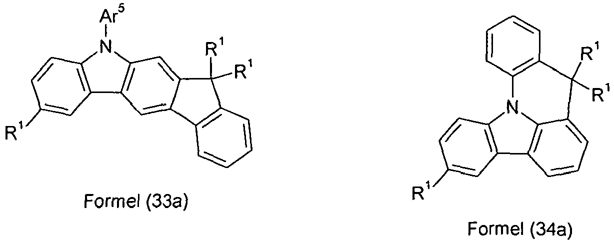 wobei die verwendeten Symbole die oben genannten Bedeutungen aufweisen.

Beispiele für geeignete lochleitende Verbindungen in der Zwischenschicht sind die im Folgenden abgebildeten aromatischen Amine.

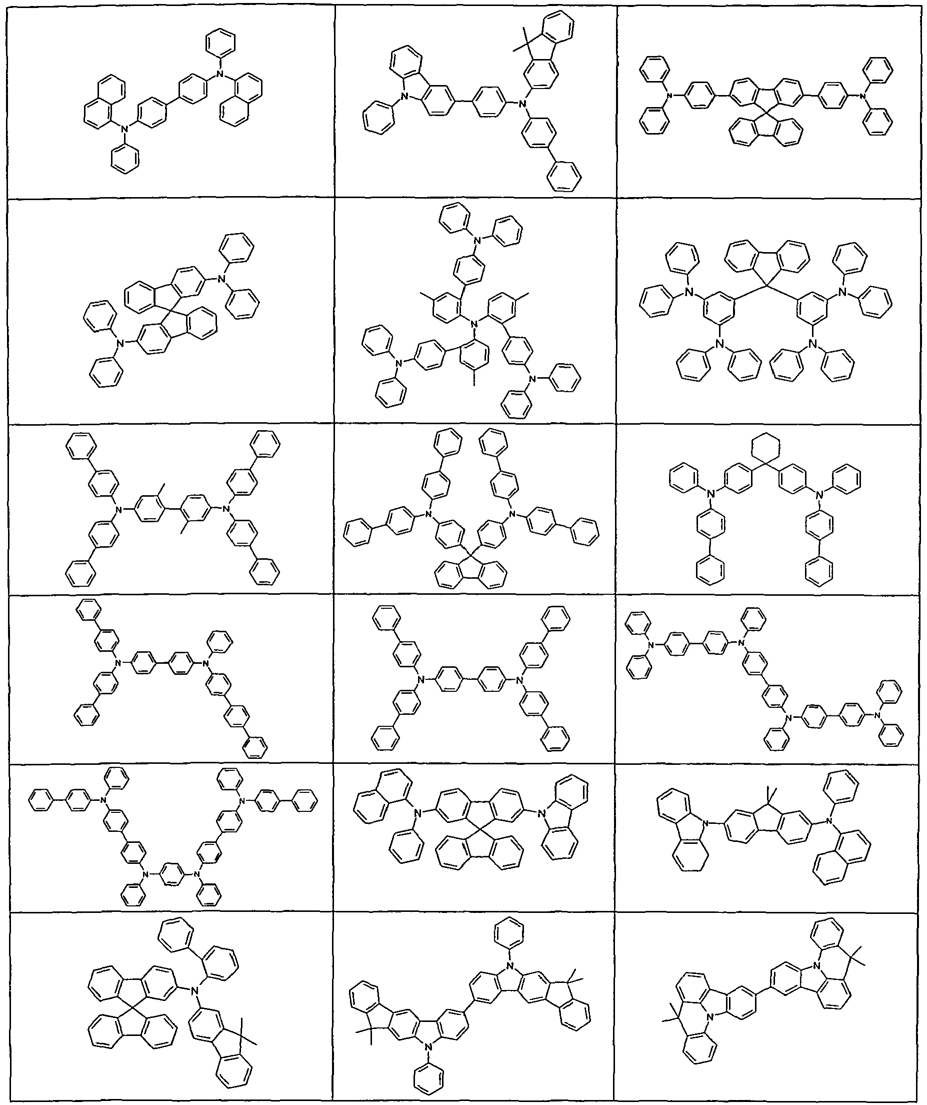

Als phosphoreszierende Verbindungen, wie sie in der Emitterschicht 1 bzw. Emitterschicht 2 eingesetzt werden, eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als Phosphoreszenzemitter Übergangsmetallverbindungen, insbesondere Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten.

Besonders bevorzugte organische Elektrolumineszenzvorrichtungen enthalten als phosphoreszierende Verbindung mindestens eine Verbindung der Formeln (35) bis (38), 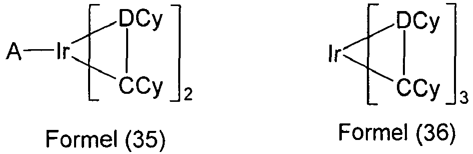 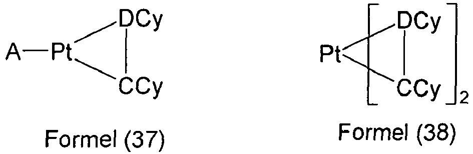 wobei R¹ dieselbe Bedeutung hat, wie oben für Formel (1) beschrieben, und für die weiteren verwendeten Symbole gilt:
- DCy: ist gleich oder verschieden bei jedem Auftreten eine cyclische Gruppe, die mindestens ein Donoratom, bevorzugt Stickstoff, Kohlenstoff in Form eines Carbens oder Phosphor, enthält, über welches die cyclische Gruppe an das Metall gebunden ist, und die wiederum einen oder mehrere Substituenten R¹ tragen kann; die Gruppen DCy und CCy sind über eine kovalente Bindung miteinander verbunden;
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹ tragen kann;
- A: ist gleich oder verschieden bei jedem Auftreten ein monoanionischer, zweizähnig chelatisierender Ligand, bevorzugt ein Diketonatligand.

Dabei kann durch Bildung von Ringsystemen zwischen mehreren Resten R¹ auch eine Brücke zwischen den Gruppen DCy und CCy vorliegen. Weiterhin kann durch Bildung von Ringsystemen zwischen mehreren Resten R¹ auch eine Brücke zwischen zwei oder drei Liganden CCy-DCy bzw. zwischen ein oder zwei Liganden CCy-DCy und dem Liganden A vorliegen, so dass es sich um ein polydentates bzw. polypodales Ligandensystem handelt. Dies ist insbesondere bevorzugt bei den Pt-Komplexen der Formel (38), wobei die Brücke zwischen den beiden CCy-DCy-Liganden bevorzugt ausgewählt ist aus NR¹ oder C(R¹)₂.

Beispiele der oben beschriebenen Emitter können den Anmeldungen WO 2000/70655, WO 2001/41512, WO 2002/02714, WO 2002/15645, EP 1191613, EP 1191612, EP 1191614, WO 2004/081017, WO 2005/033244, WO 2005/042550, WO 2005/113563, WO 2006/008069, WO 2006/061182, WO 2006/081973 und WO 2009/146770 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Verbindungen verwenden. Insbesondere ist dem Fachmann bekannt, welche phosphoreszierenden Komplexe mit welcher Emissionsfarbe emittieren.

Beispiele für geeignete phosphoreszierende Emitter sind in der folgenden Tabelle aufgeführt.

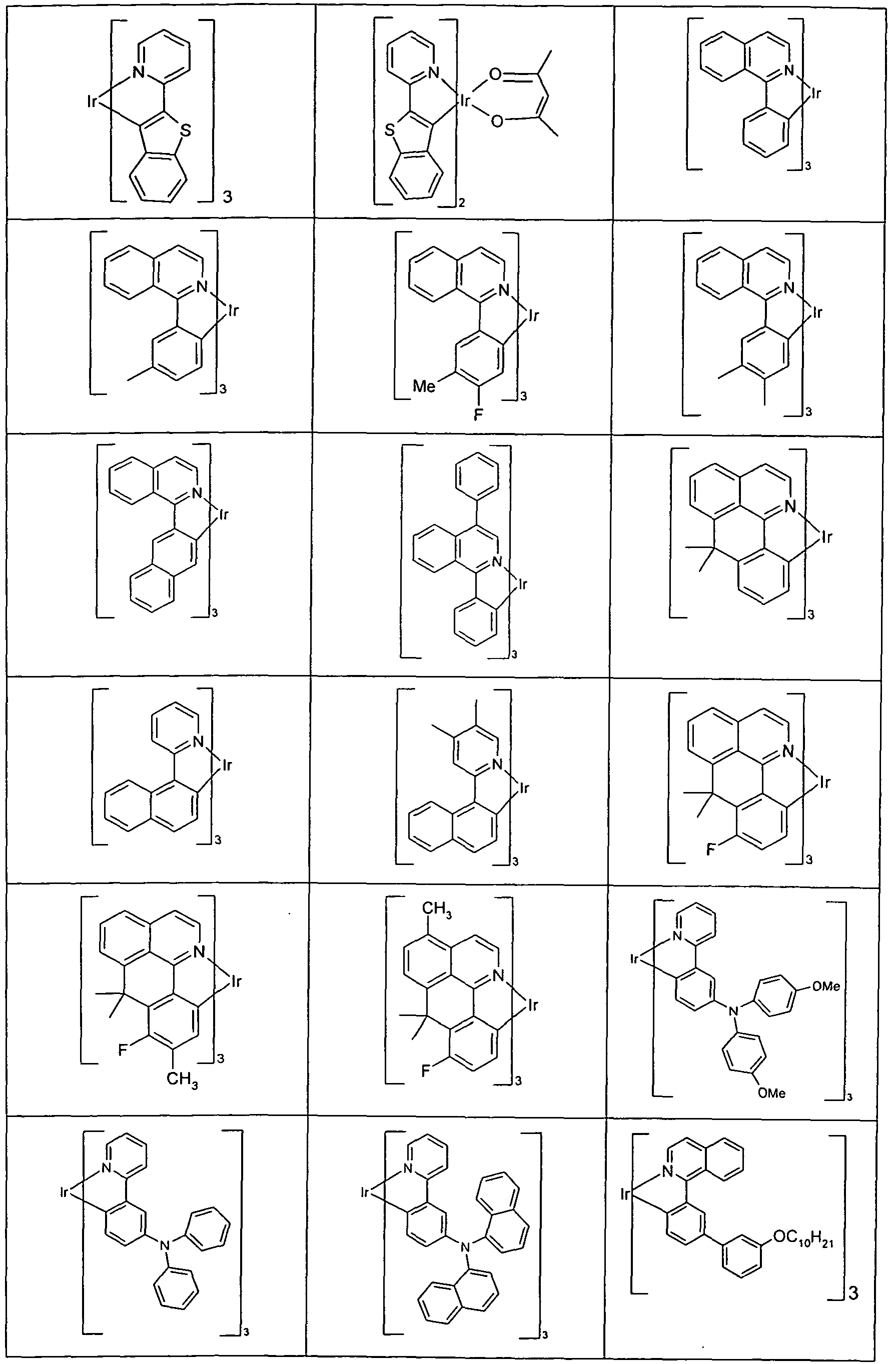

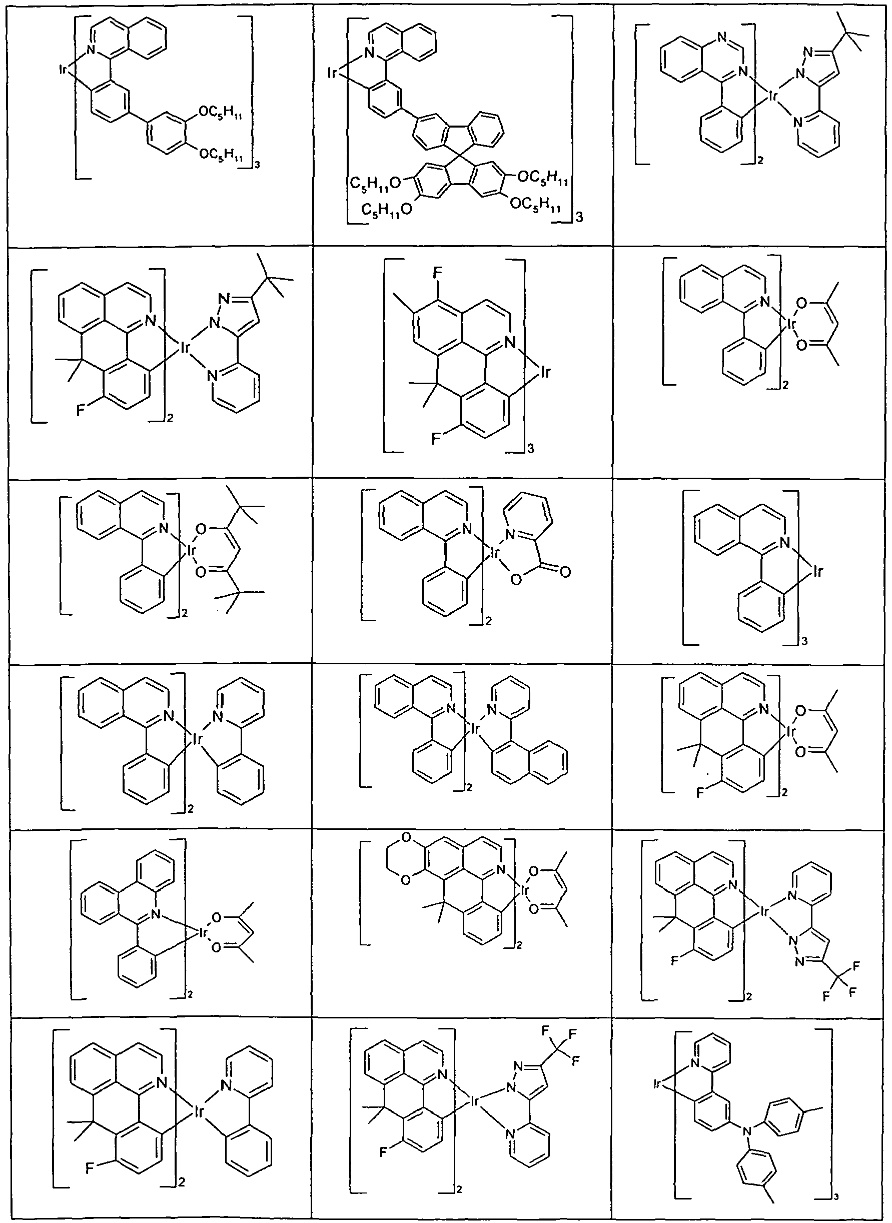

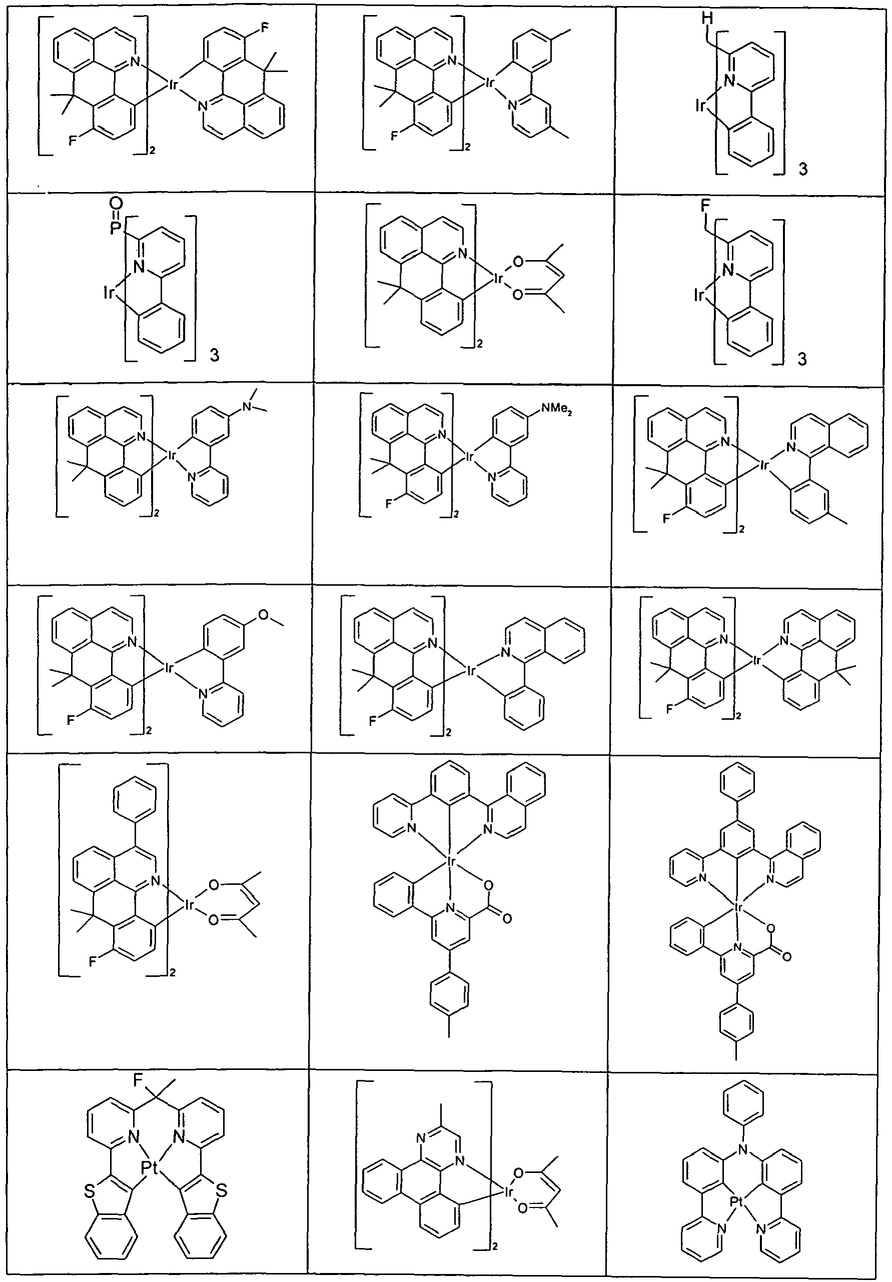

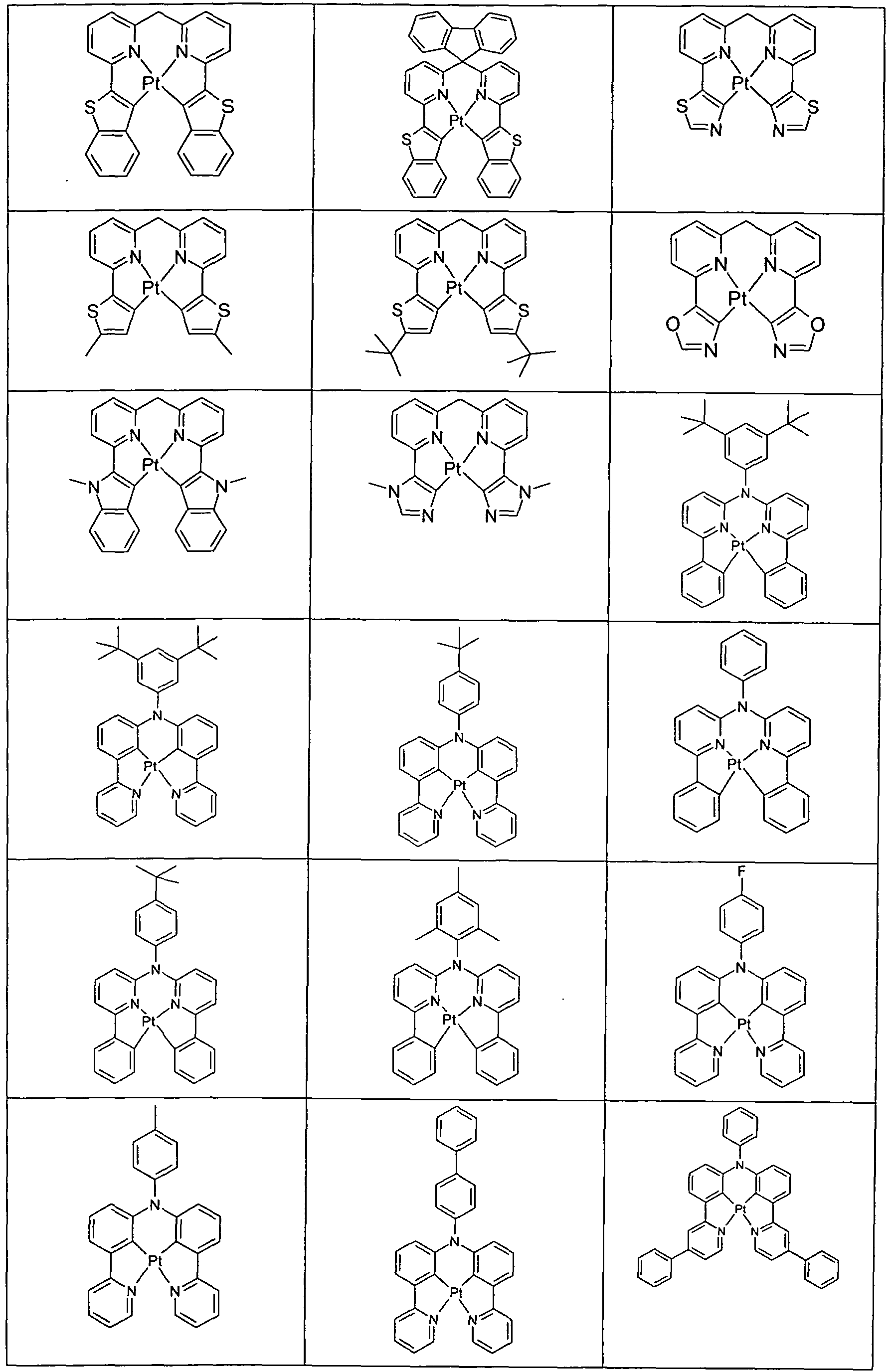

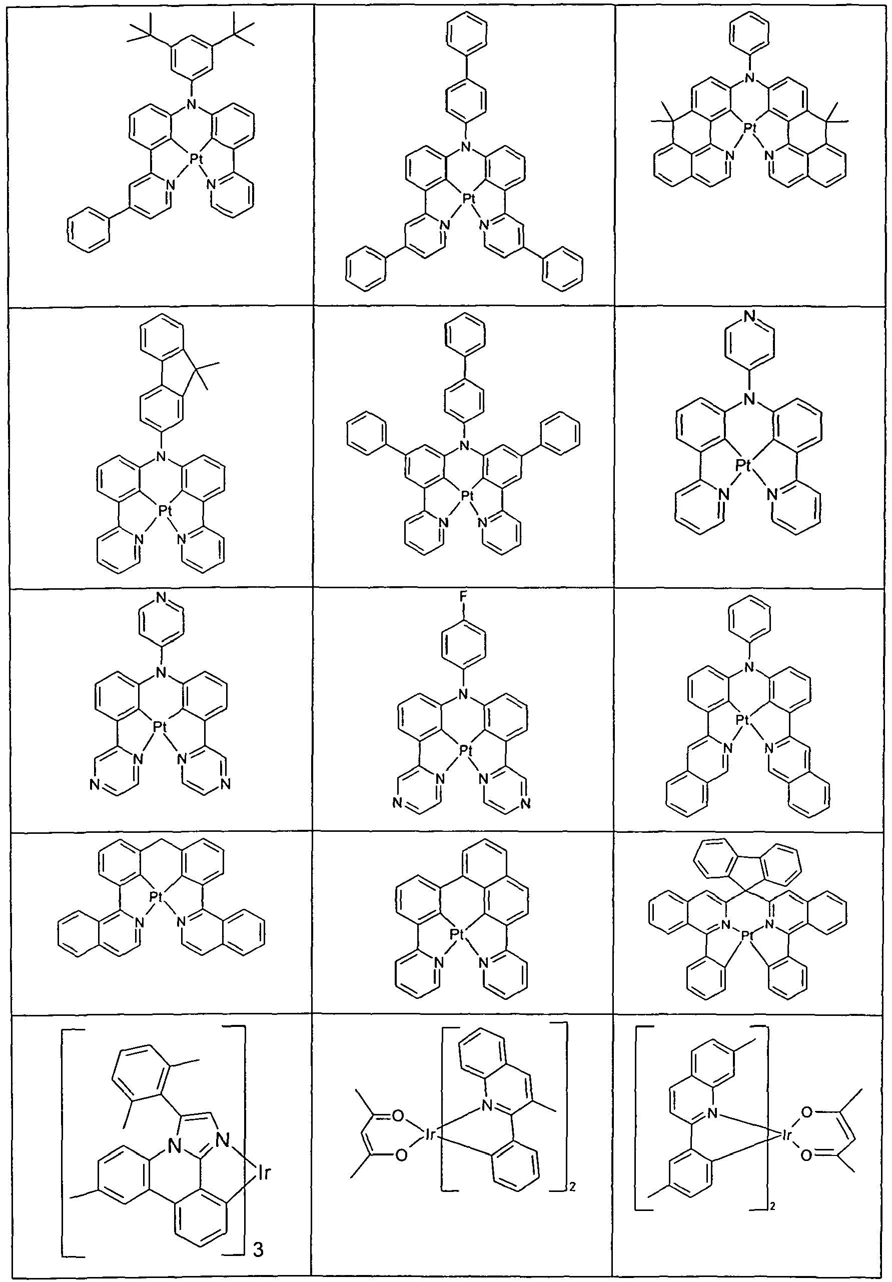

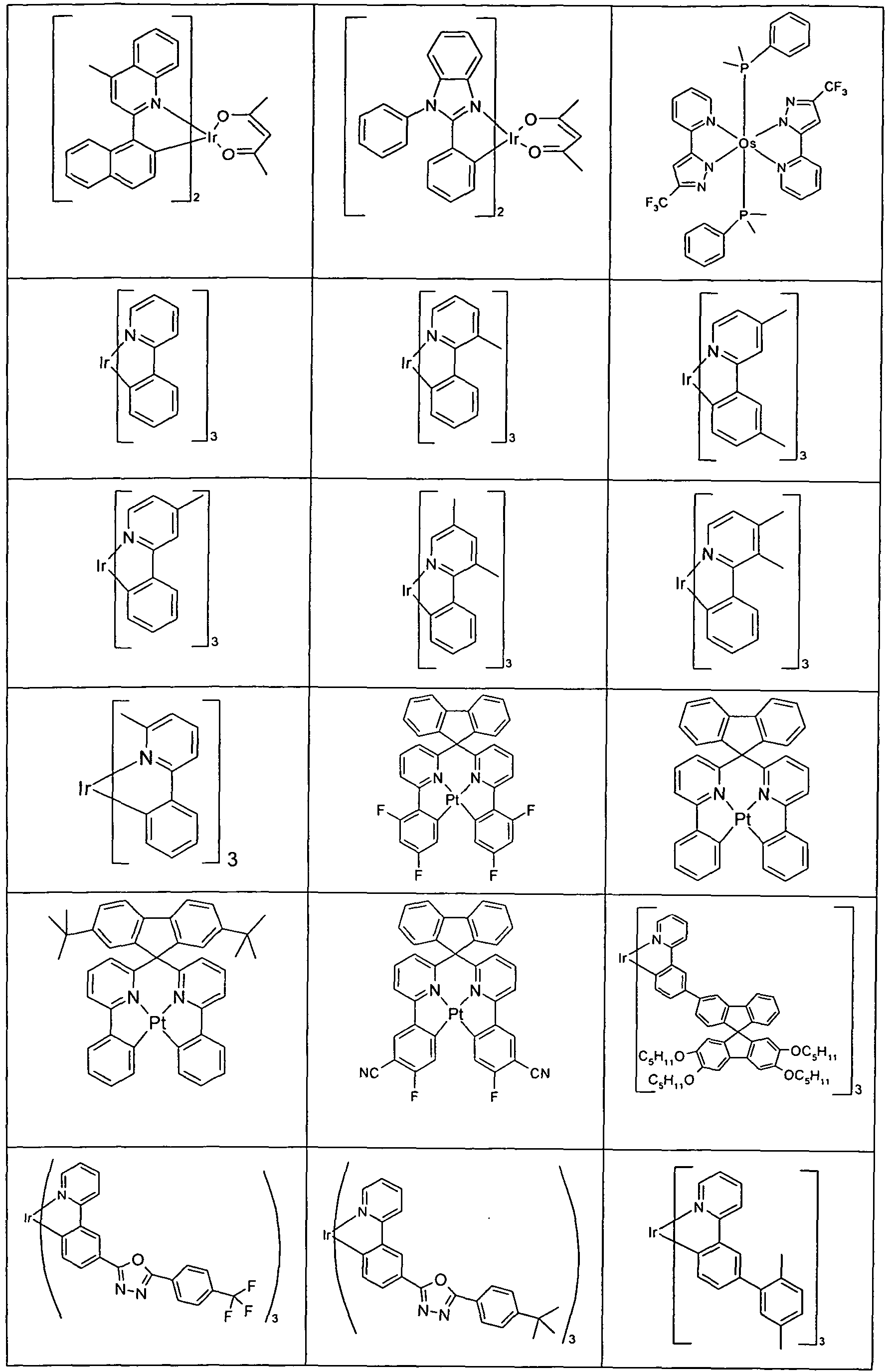

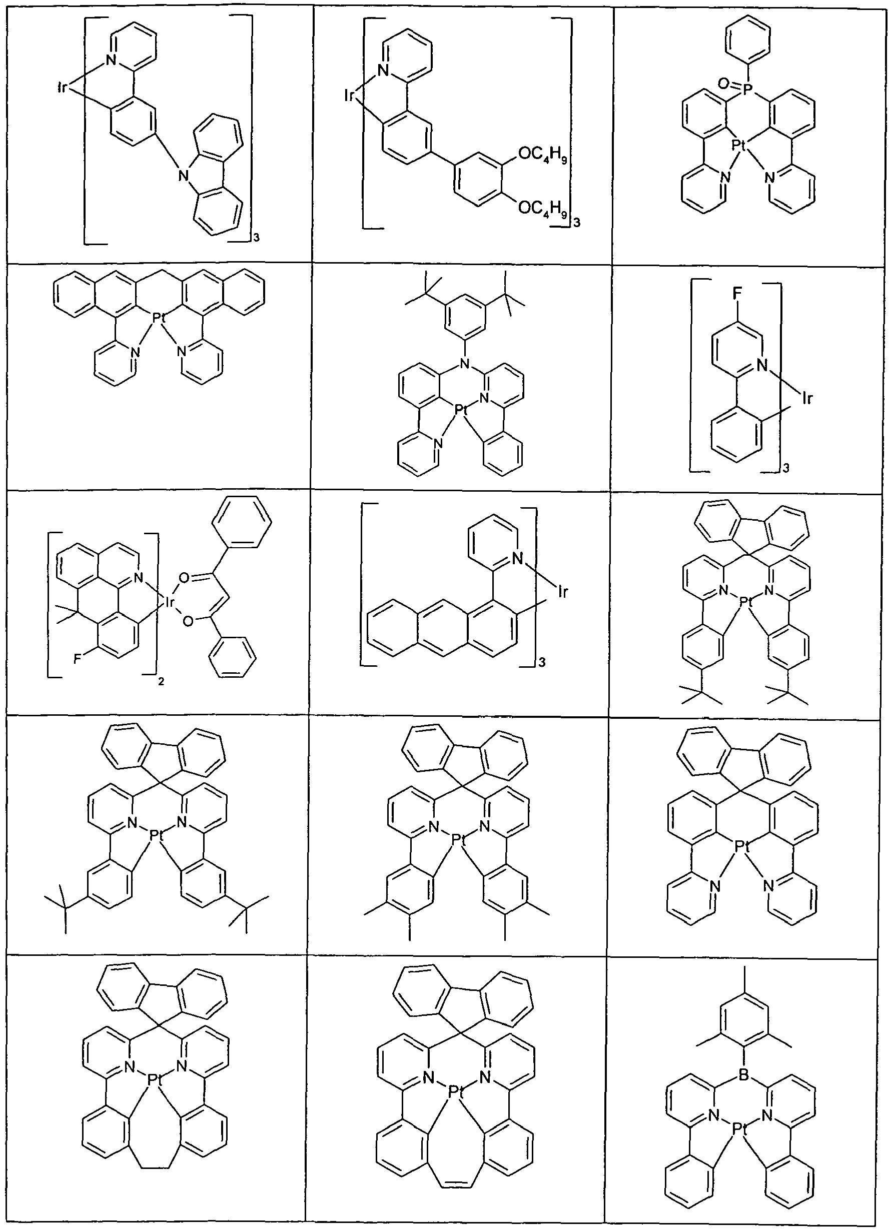

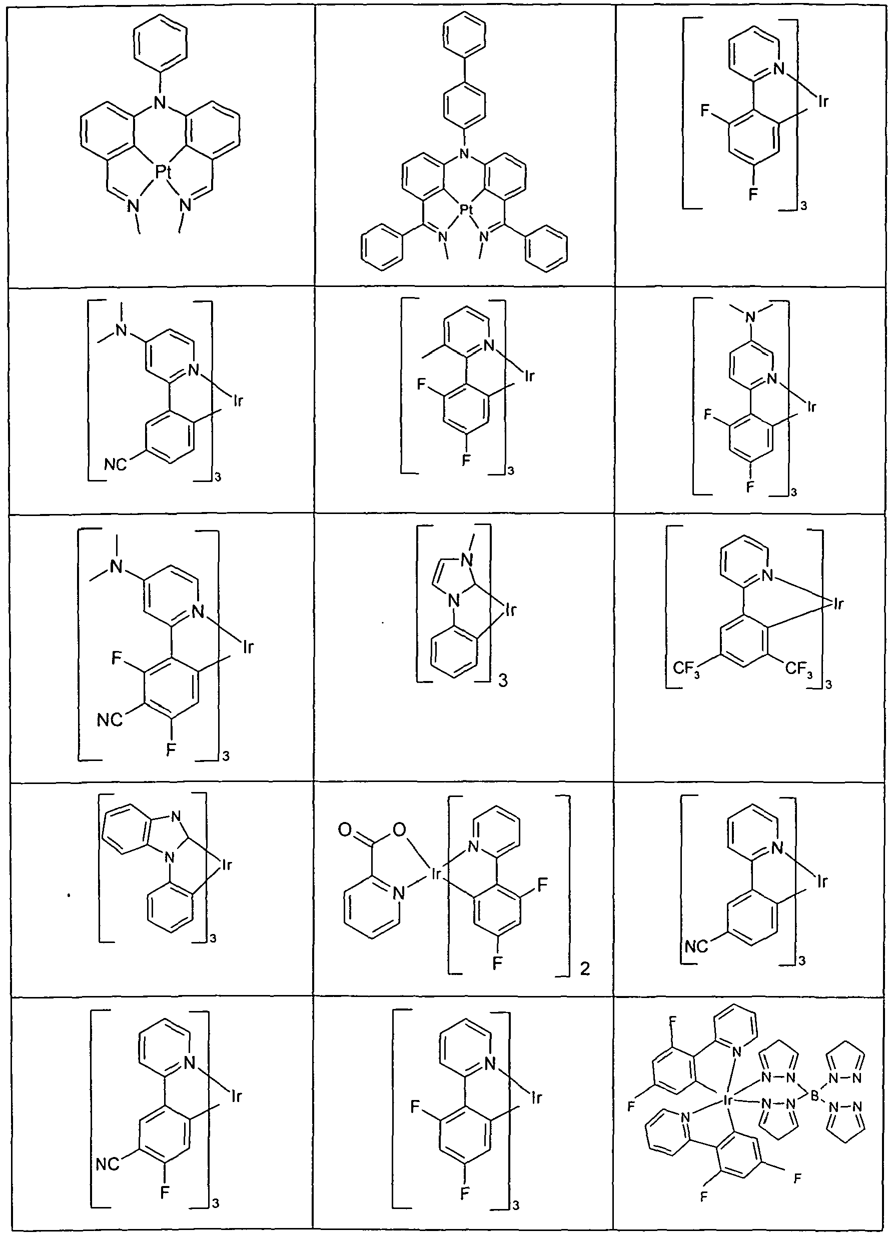

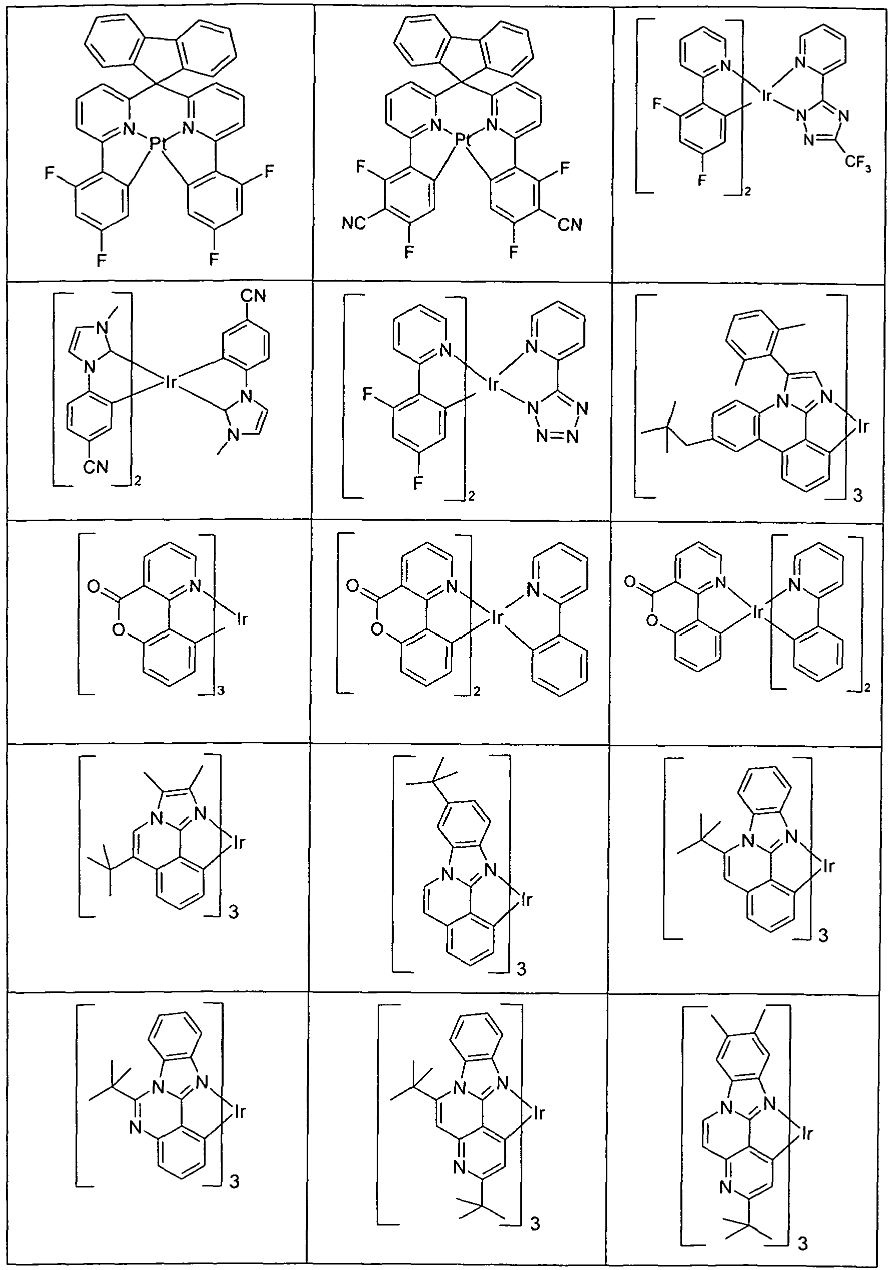

Im Folgenden werden die bevorzugten Ausführungsformen für die weiteren Schichten der OLED ausgeführt.

Erfindungsgemäß enthält die organische Elektrolumineszenzvorrichtung eine blau fluoreszierende Emitterschicht, und es handelt sich um eine weiß emittierende organische Elektrolumineszenzvorrichtung. Diese ist dadurch charakterisiert, dass sie in Summe Licht mit CIE-Farbkoordinaten im Bereich von 0.25 < CIE x < 0.45 und 0.25 < CIE y < 0.48 emittiert, bevorzugt 0.28 < CIE x < 0.38 und 0.29 < CIE y < 0.38 und besonders bevorzugt 0.30 < CIE x < 0.35 und 0.31 < CIE y < 0.35. Alternativ bevorzugt sind auch CIE-Farbkoordinaten im Bereich von 0.38 < CIE x < 0.47 und 0.38 < CIE y < 0.44 und besonders bevorzugt 0.41 < CIE x < 0.46 und 0.40 < CIE y < 0.43.

In einer bevorzugten Ausführungsform der Erfindung enthält die blau fluoreszierende Emitterschicht mindestens einen blau fluoreszierenden Dotanden und mindestens ein Matrixmaterial.

Geeignete blau fluoreszierende Dotanden sind beispielsweise ausgewählt aus der Gruppe der Monostyrylamine, der Distyrylamine, der Tristyrylamine, der Tetrastyrylamine, der Styrylphosphine, der Styrylether und der Arylamine. Unter einem Monostyrylamin wird eine Verbindung verstanden, die eine substituierte oder unsubstituierte Styrylgruppe und mindestens ein, bevorzugt aromatisches, Amin enthält. Unter einem Distyrylamin wird eine Verbindung verstanden, die zwei substituierte oder unsubstituierte Styrylgruppen und mindestens ein, bevorzugt aromatisches, Amin enthält. Unter einem Tristyrylamin wird eine Verbindung verstanden, die drei substituierte oder unsubstituierte Styrylgruppen und mindestens ein, bevorzugt aromatisches, Amin enthält. Unter einem Tetrastyrylamin wird eine Verbindung verstanden, die vier substituierte oder unsubstituierte Styrylgruppen und mindestens ein, bevorzugt aromatisches, Amin enthält. Die Styrylgruppen sind besonders bevorzugt Stilbene, die auch noch weiter substituiert sein können. Entsprechende Phosphine und Ether sind in Analogie zu den Aminen definiert. Unter einem Arylamin bzw. einem aromatischen Amin im Sinne dieser Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position oder in 2-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1,6-Position gebunden sind. Weitere bevorzugte Dotanden sind gewählt aus Indenofluorenaminen bzw. -diaminen, beispielsweise gemäß WO 2006/108497 oder WO 2006/122630, Benzoindenofluorenaminen bzw. -diaminen, beispielsweise gemäß WO 2008/006449, und Dibenzoindenofluorenaminen bzw. -diaminen, beispielsweise gemäß WO 2007/140847. Beispiele für Dotanden aus der Klasse der Styrylamine sind substituierte oder unsubstituierte Tristilbenamine oder die Dotanden, die in WO 2006/000388, WO 2006/058737, WO 2006/000389, WO 2007/065549 und WO 2007/115610 beschrieben sind. Weiterhin geeignete fluoreszierende Dotanden sind die in WO 2010/012328 offenbarten kondensierten Kohlenwasserstoffe.

Geeignete Hostmaterialien (Matrixmaterialien) für die fluoreszierenden Dotanden, insbesondere für die oben genannten Dotanden, sind beispielsweise ausgewählt aus den Klassen der Oligoarylene (z. B. 2,2',7,7'-Tetraphenylspirobifluoren gemäß EP 676461 oder Dinaphthylanthracen), insbesondere der Oligoarylene enthaltend kondensierte aromatische Gruppen, insbesondere Anthracene, der Oligoarylenvinylene (z. B. DPVBi oder Spiro-DPVBi gemäß EP 676461), der polypodalen Metallkomplexe (z. B. gemäß WO 2004/081017), der lochleitenden Verbindungen (z. B. gemäß WO 2004/058911), der elektronenleitenden Verbindungen, insbesondere Ketone, Phosphinoxide, Sulfoxide, etc. (z. B. gemäß WO 2005/084081 und WO 2005/084082), der Atropisomere (z. B. gemäß WO 2006/048268), der Boronsäurederivate (z. B. gemäß WO 2006/117052), der Benzanthracenderivate (z. B. Benz[a]anthracenderivate gemäß WO 2008/145239 oder WO 2011/012212) und der Benzophenanthrenderivate (z. B. Benz[c]phenanthrenderivate gemäß WO 2010/083869). Besonders bevorzugte Hostmaterialien sind ausgewählt aus den Klassen der Oligoarylene, enthaltend Naphthalin, Anthracen, Benzanthracen, insbesondere Benz[a]anthracen, Benzophenanthren, insbesondere Benz[c]phenanthren, und/oder Pyren oder Atropisomere dieser Verbindungen. Ganz besonders bevorzugten Matrixmaterialien für den fluoreszierenden Emitter sind Anthracenderivate. Unter einem Oligoarylen im Sinne dieser Erfindung soll eine Verbindung verstanden werden, in der mindestens drei Aryl- bzw. Arylengruppen aneinander gebunden sind.

Außer Kathode, Anode und den emittierenden Schichten, die oben beschrieben wurden, kann die organische Elektrolumineszenzvorrichtung noch weitere Schichten enthalten, welche nicht in Figur 1 bzw. Figur 2 abgebildet sind. Diese sind beispielsweise gewählt aus jeweils einer oder mehreren Lochinjektionsschichten, Lochtransportschichten, Lochblockierschichten, Elektronentransportschichten, Elektroneninjektionsschichten, Elektronenblockierschichten, Exzitonenblockierschichten, Ladungserzeugungsschichten (Charge-Generation Layers) und/oder organischen oder anorganischen p/n-Übergängen. Weiterhin können die Schichten, insbesondere die Ladungstransportschichten, auch dotiert sein. Die Dotierung der Schichten kann für einen verbesserten Ladungstransport vorteilhaft sein. Es sei aber darauf hingewiesen, dass nicht notwendigerweise jede dieser Schichten vorhanden sein muss und die Wahl der Schichten immer von den verwendeten Verbindungen abhängt.

Die Verwendung derartiger Schichten ist dem Fachmann bekannt, und er kann hierfür ohne erfinderisches Zutun alle für derartige Schichten bekannten Materialien gemäß dem Stand der Technik verwenden.

Als Kathode der erfindungsgemäßen Elektrolumineszenzvorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Ebenso bevorzugt sind Metalllegierungen, insbesondere Legierungen aus einem Alkalimetall oder Erdalkalimetall und Silber, besonders bevorzugt eine Legierung aus Mg und Ag. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, CsF, Cs₂CO₃, BaF₂, MgO, NaF, etc.), ebenso organische Alkalimetallkomplexe, z. B. Liq (Lithiumchinolinat). Die Schichtdicke dieser Schicht beträgt bevorzugt zwischen 0.5 und 5 nm.

Als Anode der erfindungsgemäßen Elektrolumineszenzvorrichtung sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Dabei muss mindestens eine der Elektroden transparent oder teiltransparent sein, um die Auskopplung von Licht zu ermöglichen. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Bei der erfindungsgemäßen organischen Elektrolumineszenzvorrichtung handelt es sich um eine Tandem-OLED, wobei eine der elektrolumineszierenden Einheiten die erfindungsgemäßen Emitterschichten 1 und 2 aufweist und die andere elektrolumineszierende Einheit eine blau fluoreszierende Einheit ist, also eine blau fluoreszierende Emitterschicht aufweist. Die beiden elektrolumineszierenden Einheiten sind durch eine Ladungserzeugungsschicht voneinander getrennt. Als Ladungserzeugungsschicht können dabei alle Schichten dienen, wie sie gemäß dem Stand der Technik für diesen Zweck verwendet werden. Dabei wird die Ladungserzeugungsschicht üblicherweise dadurch gebildet, dass eine n-leitende Schicht (bzw. eine leitende Elektroneninjektionsschicht) und eine p-leitende Schicht (bzw. eine leitende Lochinjektionsschicht) miteinander gekoppelt werden. Die p-leitenden Schichten, die gemäß dem Stand der Technik verwendet werden, umfassen beispielsweise p-dotierte organische Lochtransportmaterialien, wobei der Dotand beispielsweise F₄-TCNQ oder WO₃ ist, oder anorganische Materialien, wie zum Beispiel Indium-Zinn-Oxid (ITO), V₂O₅, WO₃ oder MoO₃. Die n-leitende Schicht ist im Allgemeinen eine dotierte organische Elektronentransportschicht, wobei als Dotand Metalle mit geringer Austrittsarbeit, wie zum Beispiel Cs, Li oder Mg, oder Metallcarbonate verwendet werden.

Es können für die weiteren Schichten der organischen Elektrolumineszenzvorrichtung generell alle weiteren Materialien, wie sie gemäß dem Stand der Technik in organischen Elektrolumineszenzvorrichtungen eingesetzt werden, auch in Kombination mit den erfindungsgemäßen Zwischenschichten eingesetzt werden.

Geeignete Ladungstransportmaterialien, wie sie in der Lochinjektions- bzw. Lochtransportschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen sowie Indenofluorenamine und Derivate (z. B. gemäß WO 2006/122630 oder WO 2006/100896), die in EP 1661888 offenbarten Aminderivate, Hexaazatriphenylenderivate (z. B. gemäß WO 2001/049806), Aminderivate mit kondensierten Aromaten (z. B. gemäß US 5,061,569), die in WO 95/09147 offenbarten Aminderivate, Monobenzoindenofluorenamine (z. B. gemäß WO 2008/006449) oder Dibenzoindenofluorenamine (z. B. gemäß WO 2007/140847). Weiterhin geeignete Lochtransport- und Lochinjektionsmaterialien sind Derivate der oben abgebildeten Verbindungen, wie sie in JP 2001/226331, EP 676461, EP 650955, WO 2001/049806, US 4780536, WO 98/30071, EP 891121, EP 1661888, JP 2006/253445, EP 650955, WO 2006/073054 und US 5061569 offenbart werden.

Als Materialien für die Elektronentransportschicht können alle Materialien verwendet werden, wie sie gemäß dem Stand der Technik als Elektronentransportmaterialien in der Elektronentransportschicht verwendet werden. Insbesondere eignen sich Aluminiumkomplexe, beispielsweise Alq₃, Zirkoniumkomplexe, beispielsweise Zrq₄, Benzimidazolderviate, Triazinderivate, beispielsweise Verbindungen der oben aufgeführten Formeln (1) oder (2), Pyrimidinderivate, beispielsweise Verbindungen der oben aufgeführten Formeln (3) bis (5), oder aromatische Ketone, beispielsweise Verbindungen der oben aufgeführten Formeln (21) bis (25). Geeignete Materialien sind beispielsweise die in der folgenden Tabelle aufgeführten Materialien. Weiterhin geeignete Materialien sind Derivate der oben abgebildeten Verbindungen, wie sie in JP 2000/053957, WO 2003/060956, WO 2004/028217 und WO 2004/080975 offenbart werden.

Es kann auch bevorzugt sein, zwei separate Elektronentransportschichten einzusetzen. Dies kann Vorteile bezüglich der Helligkeitsabhängigkeit des Farbortes der Elektrolumineszenzvorrichtung haben (siehe z. B. WO 2010/102706).

Weiterhin ist es möglich, dass eine oder mehrere Elektronentransportschichten dotiert sind. Geeignete Dotanden sind Alkalimetalle oder Alkalimetallverbindungen, wie zum Beispiel Liq (Lithiumchinolinat). In einer bevorzugten Ausführungsform der Erfindung ist die Elektronentransportschicht insbesondere dann dotiert, wenn das Elektronentransportmaterial ein Benzimidazolderivat oder ein Triazinderivat ist. Der bevorzugte Dotand ist dann Liq.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es sei jedoch angemerkt, dass der Druck auch noch geringer sein kann, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle-Printing, hergestellt werden. Hierfür sind lösliche Verbindungen nötig. Hohe Löslichkeit lässt sich durch geeignete Substitution der Verbindungen erreichen. Dabei können nicht nur Lösungen aus einzelnen Materialien aufgebracht werden, sondern auch Lösungen, die mehrere Verbindungen enthalten, beispielsweise Matrixmaterialien und Dotanden.

Die organische Elektrolumineszenzvorrichtung kann auch hergestellt werden, indem eine oder mehrere Schichten aus Lösung aufgebracht werden und eine oder mehrere andere Schichten aufgedampft werden.

Diese Verfahren sind dem Fachmann generell bekannt und können von ihm ohne erfinderisches Zutun auf die erfindungsgemäßen organischen Elektrolumineszenzvorrichtungen angewandt werden.

Die erfindungsgemäße organische Elektrolumineszenzvorrichtung weist folgende überraschende Vorteile gegenüber dem Stand der Technik auf:
1. Die erfindungsgemäße organische Elektrolumineszenzvorrichtung weist eine sehr gute Lebensdauer auf. So ist die Lebensdauer vergleichbar mit der Lebensdauer einer Elektrolumineszenzvorrichtung, welche zwei separate emittierende Schichten aufweist.
2. Die erfindungsgemäße organische Elektrolumineszenzvorrichtung weist gleichzeitig einen sehr geringen Farbshift mit der Lebensdauer auf. Dabei ist der Farbshift vergleichbar gut wie der Farbshift, der erhalten wird, wenn die unterschiedlich emittierenden Emitter in dieselbe Emissionsschicht eingebracht werden.

Es ist insbesondere überraschend, dass die beiden oben genannten Vorteile gleichzeitig auftreten, da es gemäß dem Stand der Technik häufig entweder organische Elektrolumineszenzvorrichtungen mit zwei oder mehr emittierenden Schichten mit einer guten Lebensdauer oder solche mit einem geringen Farbshift beschrieben werden, nicht aber solche, bei denen diese Effekte gleichzeitig auftreten.

Die Erfindung wird durch die nachfolgenden Beispiele genauer beschrieben, ohne sie dadurch einschränken zu wollen. Der Fachmann kann, ohne erfinderisch tätig zu werden, die Erfindung im gesamten offenbarten Bereich ausführen und so weitere erfindungsgemäße organische Elektrolumineszenzvorrichtungen herstellen.

### Beispiele:

### Herstellung und Charakterisierung organischer Elektrolumineszenzvorrichtungen

Erfindungsgemäße Elektrolumineszenzvorrichtungen können, wie beispielsweise in WO 2005/003253 allgemein beschrieben, hergestellt werden.

Die Strukturen der verwendeten Materialien sind der Übersichtlichkeit halber im Folgenden abgebildet.

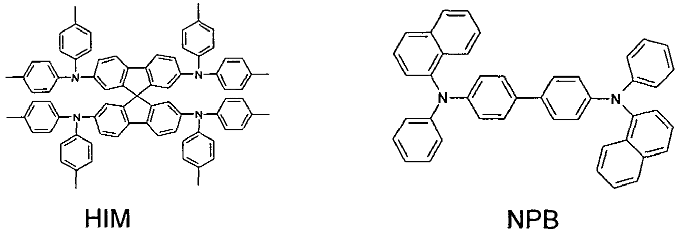

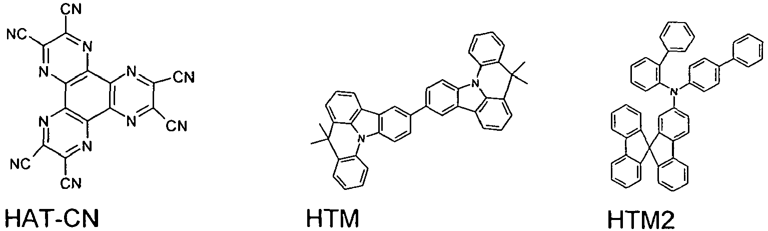

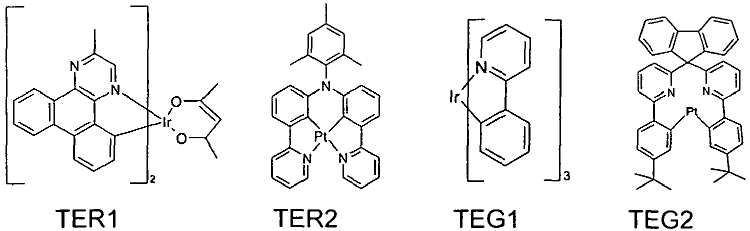

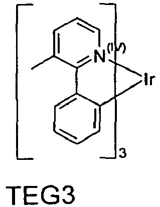

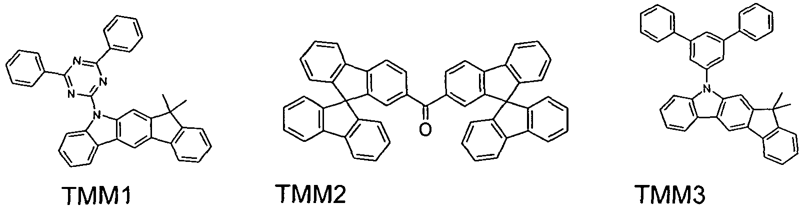

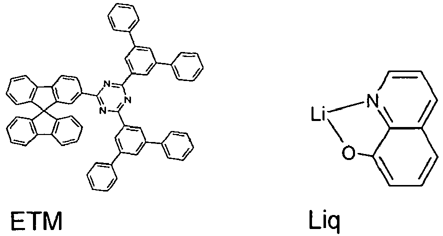

Diese OLEDs werden standardmäßig charakterisiert; hierfür werden die Elektrolumineszenzspektren und Farbkoordinaten (gemäß CIE 1931), die Effizienz (gemessen in cd/A) in Abhängigkeit von der Helligkeit, die Betriebsspannung, berechnet aus Strom-Spannungs-Leuchtdichte-Kennlinien (IUL-Kennlinien), und die Lebensdauer (LT70% bei 4000 cd/m² Starthelligkeit) bestimmt. Außerdem wird der Drift der Farbkoordinaten über die Lebensdauermessung verfolgt und die Differenz zwischen der Startfarbe und der Farbe zum Zeitpunkt LT70% ermittelt. Die erhaltenen Ergebnisse sind in Tabelle 1 zusammengefasst.

Im Folgenden werden die Ergebnisse verschiedener OLEDs gegenübergestellt. Es handelt sich dabei jeweils um OLEDs, die zwei verschiedenfarbige phosphoreszente Emitter in unterschiedlichen Schichtarchitekturen (erfindungsgemäß oder als Vergleich) beinhalten.

### Beispiel 1:

Beispiele 1 a-c (nicht gemäß der Erfindung) werden durch folgenden Schichtaufbau realisiert: 50 nm HIM / 10 nm HAT-CN / 50 nm HIM / 20 nm NPB / 20 nm Mischschicht bestehend aus (im Fall 1a) HTM (90%), TEG1 (5%), TER1 (5%); (im Fall 1b) HTM (80%), TEG1 (10%), TER1 (10%); (im Fall 1c) HTM (75%), TEG1 (15%), TER1 (10%) / 20 nm Mischschicht bestehend aus TMM1 (85%) und TEG1 (15%) / 10 nm TMM2 / 45 nm Mischschicht bestehend aus ETM (50%) und Liq (50%) / 100 nm Al.

### Beispiel 2 (Vergleichsbeispiel):

Beispiel 2 wird durch folgenden Schichtaufbau realisiert: 50 nm HIM / 10 nm HAT-CN / 50 nm HIM / 20 nm NPB / 20 nm Mischschicht bestehend aus HTM (95%) und TER1 (5%) / 20 nm Mischschicht bestehend aus TMM1 (85%) und TEG1 (15%) / 10 nm TMM2 / 45 nm Mischschicht bestehend aus ETM (50%) und Liq (50%) / 100 nm Al.

Das Beispiel 1a entspricht genau der Architektur des Vergleichsbeispiels 2 bis auf die Tatsache, dass in der Emitterschicht 1 nicht nur 5% TER1, sondern zusätzlich 5% TEG1 eindotiert sind. An den Leistungsdaten ist deutlich zu erkennen, dass im Fall 1a bei sehr ähnlicher Gesamtfarbe und Effizienz eine deutlich verbesserte Lebensdauer im Vergleich zu Beispiel 2 erzielt wird. Darüber hinaus ist der Farbshift mit der Lebensdauer verringert.

Beispiel 1b und c illustrieren, dass man durch eine Variation der Emitterkonzentrationen in der Emitterschicht 1 Farbe, Effizienz und Lebensdauer leicht verschieben kann. Der Effekt einer verbesserten Lebensdauer und eines geringeren Farbshifts bleibt aber bestehen. Es ist somit kein Effekt, der nur auf einer ganz speziellen Wahl der Emitterkonzentrationen beruht.

### Beispiel 3 (Vergleichsbeispiel):

Beispiel 3 wird durch folgenden Schichtaufbau realisiert: 50 nm HIM / 10 nm HAT-CN / 50 nm HIM / 20 nm NPB / 20 nm Mischschicht bestehend aus NPB (95%), TER1 (5%) / 20 nm Mischschicht bestehend aus TMM1 (85%) und TEG1 (15%) / 10 nm TMM2/45 nm Mischschicht bestehend aus ETM (50%) und Liq (50%) / 100 nm Al.

Beispiel 3 entspricht Beispiel 2 bis auf den Unterschied, dass als Matrix für den orangen Dotanden anstatt HTM das weit verbreitete Material NPB verwendet wurde. Auch hier ergibt sich im Vergleich zum erfindungsgemäßen Beispiel 1a eine schlechtere Lebensdauer und ein erhöhter Farbshift. Dieses Beispiel soll illustrieren, dass der Farbshift nicht von der Wahl der Matrix der Emitterschicht 1 abhängt, sondern davon, ob erfindungsgemäß zwei Emitter oder nur einer in die Schicht eindotiert ist.

### Beispiel 4 (Vergleichsbeispiel):

Beispiel 4 wird durch folgenden Schichtaufbau realisiert: 50 nm HIM / 10 nm HAT-CN / 50 nm HIM / 30 nm NPB / 30 nm Mischschicht bestehend aus TMM1 (84.7%), TEG1 (15%), TER1 (0.3%) / 10 nm TMM2 / 45 nm Mischschicht bestehend aus ETM (50%) und Liq (50%) / 100 nm Al.

Dieses Vergleichsbeispiel enthält nur eine emittierende Schicht, in die beide Emitter derart eindotiert sind, dass sie ebenfalls in einem ausgewogenen Verhältnis leuchten. In diesem Fall, kann die Emitterkonzentration nicht in einem großen Bereich variiert werden, sondern muss im Gegenteil sehr empfindlich genau eingestellt werden, um eine ausgewogene Mischfarbe zu erhalten. Daraus resultieren die dargestellten Konzentrationen für 15% für TEG1 und 0.3% für TER1. An den Leistungsdaten lässt sich erkennen, dass in diesem Fall zwar ein sehr geringer Farbshift mit der Lebensdauer vorliegt, die Lebensdauer an sich ist mit 350 h aber sehr gering, noch deutlich geringer als bei den anderen Vergleichsbeispielen.

Insgesamt zeigen die Beispiele somit, dass durch die Kombination einer zweifach dotierten Emitterschicht mit einer einfach dotierten, sowohl ein geringer Farbshift - geringer als bei Kombination von zwei einfach dotierten Schichten - als auch eine sehr gute Lebensdauer erzielt werden kann. Besonders überraschend ist hierbei Folgendes: Bezüglich Farbshift könnte man das erhaltene Ergebnis als einen Kompromiss bzw. Mittelwert aus den beiden Farbshifts (dem starken bei Verwendung zweier Einfachdotierungen und dem geringen bei Verwendung einer Zweifachdotierung) ansehen. Die Lebensdauer bei der Architektur gemäß den Beispielen 1 a-c hingegen ist kein Mittelwert zwischen der geringen Lebesdauer bei der Zweifachdotierung und der etwa doppelt so hohen bei der Kombination zweier Einfachdotierungen, sondern ist deutlich erhöht gegenüber allen Vergleichsarchitekturen.

Um zu demonstrieren, dass dieses Verhalten nicht auf der konkreten Wahl der Matrix- oder Emittermateralien beruht, werden im Folgenden noch weitere Beispiel ausgeführt, die mit anderen Materialien, so z. B. auch auf Pt anstatt Ir basierenden Emittern realisiert wurden.

### Beispiel 5:

Beispiel 5 (nicht gemäß der Erfindung) wird durch folgenden Schichtaufbau realisiert: 50 nm HIM / 10 nm HAT-CN / 50 nm HIM / 20 nm NPB / 20 nm Mischschicht bestehend aus HTM2 (75%), TEG1 (15%), TER1 (10%) / 20 nm Mischschicht bestehend aus TMM1 (45%), TMM3 (40%) und TEG1 (15%) / 10 nm TMM1 / 45 nm Mischschicht bestehend aus ETM (50%) und Liq (50%) / 100 nm Al.

### Beispiel 6 (Vergleichsbeispiel):

Beispiel 6 wird durch folgenden Schichtaufbau realisiert: 50 nm HIM / 10 nm HAT-CN / 50 nm HIM / 20 nm NPB / 20 nm Mischschicht bestehend aus HTM2 (85%), TER1 (10%) / 20 nm Mischschicht bestehend aus TMM1 (45%), TMM3 (40%) und TEG1 (15%) / 10 nm TMM1 / 45 nm Mischschicht bestehend aus ETM (50%) und Liq (50%) / 100 nm AI.

Beispiele 5 und 6 bestehen aus dem gleichen Schichtaufbau bis auf der Verwendung der Doppeldotierung in der Emitterschicht 1 in Beispiel 5 im Vergleich zur Einfachdotierung in Vergleichsbeispiel 6. Der direkte Vergleich der beiden Fälle verdeutlicht wiederum den Vorteil der Architektur gemäß Beispiel 5. In diesem Fall erlauben beide Schichtarchitekturen eine sehr gute Lebensdauer, der Farbshift ist im Fall 5 allerdings zusätzlich verbessert.

Des Weiteren ist in Beispiel 5 und 6 ein anderes lochleitendes Matrixmaterial (HTM2) verwendet als in den Beispielen 2 und 3 (HTM), dessen chemische Struktur auf Monoamin-Basis eine ganz andere ist, als die von HTM. Dieses Beispiel soll verdeutlichen, dass der Vorteil der Architektur gemäß den Beispielen 5 und 6 nicht eingeschränkt ist auf eine spezielle Klasse von lochleitenden Matrizes.

Beispiele 5 und 6 enthalten außerdem in der zweiten Emitterschicht eine gemischte Matrix (aus TMM1 und TMM3). Eine gemischte Matrix anstelle einer einfachen kann (nicht unüblich bei OLEDs) Verwendung finden, um die Leistungsdaten insgesamt zu verbessern. Die Beispiele zeigen somit aber auch, dass der Vorteil der Architektur auch im Fall, dass die OLED an anderer Stelle noch weitere optimierte Schichten aufweist, erhalten bleibt.

### Beispiel 7:

Beispiel 7 (nicht gemäß der Erfindung) wird durch folgenden Schichtaufbau realisiert: 50 nm HIM / 10 nm HAT-CN / 50 nm HIM / 20 nm NPB / 20 nm Mischschicht bestehend aus HTM (85%), TEG2 (10%), TER2 (5%) / 20 nm Mischschicht bestehend aus TMM1 (95%) und TEG2 (5%) / 10 nm TMM2 / 45 nm Mischschicht bestehend aus ETM (50%) und Liq (50%) / 100 nm Al.

### Beispiel 8 (Vergleichsbeispiel):

Beispiel 8 wird durch folgenden Schichtaufbau realisiert: 50 nm HIM / 10 nm HAT-CN / 50 nm HIM / 20 nm NPB / 20 nm Mischschicht bestehend aus HTM (95%) und TER2 (5%) / 20 nm Mischschicht bestehend aus TMM1 (95%) und TEG2 (5%) / 10 nm TMM2 / 45 nm Mischschicht bestehend aus ETM (50%) und Liq (50%) / 100 nm Al.

In den Beispielen 7 und 8 werden andere phosphoreszierende Emitter auf Pt anstatt Ir-Basis verwendet. Aufgrund der tiefer roten Emission von TER2 im Vergleich zu TER1 ergibt sich eine tiefer orange Mischfarbe, wodurch die Absolutwerte von Effizienz und Lebensdauer geringer ausfallen als in den bisherigen Beispielen. Unabhängig davon zeigt sich aber auch durch den Einsatz der zweifach dotierten Emitterschicht 1 eine deutliche Verbesserung in der Lebensdauer und geringfügig auch im Farbshift.

### Beispiel 9:

Beispiel 9 (nicht gemäß der Erfindung) wird durch folgenden Schichtaufbau realisiert: 50 nm HIM / 10 nm HAT-CN / 50 nm HIM / 20 nm NPB / 20 nm Mischschicht bestehend aus HTM2 (75%), TEG1 (15%), TER1 (10%) / 20 nm Mischschicht bestehend aus TMM1 (45%), TMM3 (40%) und TEG3 (15%) / 10 nm TMM1/45 nm Mischschicht bestehend aus ETM (50%) und Liq (50%) / 100 nm Al.

### Beispiel 10:

Erfindungsgemäßes Beispiel 10 wird durch folgenden Schichtaufbau realisiert: 50 nm HIM / 10 nm HAT-CN / 50 nm HIM / 20 nm NPB / 20 nm Mischschicht bestehend aus HTM2 (75%), TEG3 (15%), TER1 (10%) / 20 nm Mischschicht bestehend aus TMM1 (45%), TMM3 (40%) und TEG1 (15%) / 10 nm TMM1 /45 nm Mischschicht bestehend aus ETM (50%) und Liq (50%) / 100 nm Al.

Beispiele 9 und 10 sind analog zu Beispiel 5 aufgebaut, mit dem Unterschied, dass hier in beiden Emitterschichten jeweils nicht derselbe kurzwellige (grün emittierende) Dotand verwendet wird, sondern mit TEG1 und TEG3 zwei unterschiedliche, deren Emissionsmaximum sich um weniger als 10 nm unterscheidet. Hier kann als Vergleichsbeispiel wieder Beispiel 6 dienen, und der Vergleich verdeutlicht, dass der Schichtaufbau in den Beispielen 9 und 10 zu einem reduzierten Farbshift mit der Alterung führt.

**Tabelle 1: Device-Ergebnisse**

| Bsp. (*= Vgl) | 1. Emissionsschicht | 2. Emissionsschicht | Effizienz [cd/A] bei 1000 cd/m² | CIE x/y bei 1000 cd/m² | LT70% [h], bei Start 4000 cd/m² | Delta CIE x/y nach LT70% |
|---|---|---|---|---|---|---|
| 1a | HTM (90%), TEG1 (5%), TER1 (5%) | TMM1 (85%), TEG1 (15%) | 39 | 0.488/ 0.486 | 1100 | -0.015/ +0.010 |
| 1b | HTM (80%), TEG1 (10%), TER1 (10%) | TMM1 (85%), TEG1 (15%) | 35 | 0.506/ 0.470 | 1200 | -0.018/ +0.015 |
| 1c | HTM (75%), TEG1 (15%), TER1 (10%) | TMM1 (85%), TEG1 (15%) | 35 | 0.513/ 0.464 | 1400 | -0.019/ +0.016 |
| 2 (Vgl) | HTM (95%), TER1 (5%) | TMM1 (85%), TEG1 (15%) | 40 | 0.480/ 0.492 | 700 | -0.028/ +0.023 |
| 3 (Vgl) | NPB (95%), TER1 (5%) | TMM1 (85%), TEG1 (15%) | 41 | 0.494/ 0.483 | 800 | -0.030/ +0.024 |
| 4 (Vgl) | - | TMM1 (84.7%), TEG1 (15%), TER1 (0.3%) | 38 | 0.522/ 0.467 | 350 | -0.005/ +0.04 |
| 5 | HTM2 (75%), TEG1 (15%), TER1 (10%) | TMM1 (45%), TMM3 (40%), TEG1 (15%) | 44 | 0.492/ 0.485 | 1800 | -0.015/ +0.012 |
| 6 (Vgl) | HTM2 (90%), TER1 (10%) | TMM1 (45%), TMM3 (40%), TEG1 (15%) | 44 | 0.504/ 0.477 | 1800 | -0.035/ +0.022 |
| 7 | HTM (85%) TEG2 (10%) TER2 (5%) | TMM1 (95%) TEG2 (5%) | 19 | 0.632/ 0.366 | 500 | -0.014/ +0.008 |
| 8 (Vgl) | HTM (95%) TER2 (5%) | TMM1 (95%) TEG2 (5%) | 18 | 0.620/ 0.377 | 150 | -0.018/ +0.009 |
| 9 | HTM2 (75%), TEG1 (15%), TER1 (10%) | TMM1 (45%), TMM3 (40%), TEG3 (15%) | 40 | 0.502/ 0.478 | 2100 | -0.017/ +0.014 |
| 10 | HTM2 (75%), TEG3 (15%), TER1 (10%) | TMM1 (45%), TMM3 (40%), TEG1 (15%) | 42 | 0.499/ 0.478 | 1900 | -0.014/ +0.012 |

## Patentansprüche

1. Organische Elektrolumineszenzvorrichtung, enthaltend in dieser Reihenfolge: Anode, phosphoreszierende Emitterschicht 1, phosphoreszierende Emitterschicht 2, die mit Emitterschicht 1 in direktem Kontakt steht, und Kathode, **dadurch gekennzeichnet, dass** Emitterschicht 1 ein lochleitendes Matrixmaterial und zwei unterschiedliche phosphoreszierende Emitter enthält und Emitterschicht 2 ein elektronenleitendes Matrixmaterial und einen phosphoreszierenden Emitter enthält, wobei der phosphoreszierende Emitter der Emitterschicht 2 dasselbe Emissionsmaximum hat wie der kürzerwellig phosphoreszierenden Emitter der Emitterschicht 1, **dadurch gekennzeichnet, dass** es sich um eine weiß emittierende Tandem-OLED handelt, die zusätzlich eine blau fluoreszierende Emitterschicht aufweist und die zwischen der blau fluoreszierenden Emitterschicht und der Emitterschicht 2 eine Ladungserzeugungsschicht aufweist.

2. Organische Elektrolumineszenzvorrichtung nach Anspruch 1, **dadurch gekennzeichnet, dass** der phosphoreszierende Emitter der Emitterschicht 2 identisch ist zu dem kürzerwellig phosphoreszierenden Emitter der Emitterschicht 1.

3. Organische Elektrolumineszenzvorrichtung nach Anspruch 1 oder 2, **dadurch gekennzeichnet, dass** es sich bei der phosphoreszierenden Emitterschicht 1 um eine gelb, orange oder rot emittierende Schicht und bei der phosphoreszierenden Emitterschicht 2 um eine grün oder gelb emittierende Schicht handelt.

4. Organische Elektrolumineszenzvorrichtung nach einem oder mehreren der Ansprüche 1 bis 3, **dadurch gekennzeichnet, dass** Emitterschicht 1 und Emitterschicht 2 in Summe Licht mit Farbkoordinaten 0.45 ≤ CIE x ≤ 0.58 emittieren.

5. Organische Elektrolumineszenzvorrichtung nach einem oder mehreren der Ansprüche 1 bis 4, **dadurch gekennzeichnet, dass** die Triplettenergie T₁ des lochleitenden Matrixmaterials größer ist als die des langwelligsten Emitters.

6. Organische Elektrolumineszenzvorrichtung nach einem oder mehreren der Ansprüche 1 bis 5, **dadurch gekennzeichnet, dass** die Emitterschicht 2 eine Mischung aus einem elektronenleitenden und mindestens einem weiteren Matrixmaterial enthält.

7. Organische Elektrolumineszenzvorrichtung nach einem oder mehreren der Ansprüche 1 bis 6, **dadurch gekennzeichnet, dass** der kürzerwellig phosphoreszierende Emitter in Emitterschicht 1 in einer Konzentration von 3 bis 25 Vol.-% und der längerwellig phosphoreszierende Emitter in Emitterschicht 1 in einer Konzentration von 2 bis 15 Vol.-% vorliegt und dass der phosphoreszierende Emitter in Emitterschicht 2 in einer Konzentration von 2 bis 20 Vol.-% vorliegt.

8. Organische Elektrolumineszenzvorrichtung nach Anspruch 7, **dadurch gekennzeichnet, dass** das elektronenleitende Matrixmaterial in Emitterschicht 2 ausgewählt ist aus Verbindungen der Formeln (1) bis (5), 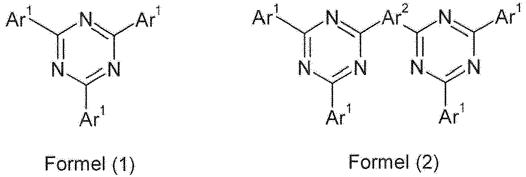 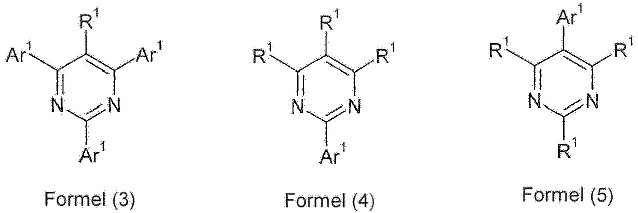 wobei für die verwendeten Symbole gilt:
Ar¹ ist gleich oder verschieden bei jedem Auftreten ein monovalentes aromatisches oder heteroaromatisches Ringsystem mit 5 bis 60 aromatischen Ringatomen, welches jeweils mit einem oder mehreren Resten R¹ substituiert sein kann;
Ar² ist ein bivalentes aromatisches oder heteroaromatisches Ringsystem mit 5 bis 60 aromatischen Ringatomen, welches mit einem oder mehreren Resten R¹ substituiert sein kann;
R¹ ist bei jedem Auftreten gleich oder verschieden H, D, F, Cl, Br, I, CHO, C(=O)Ar³, P(=O)(Ar³)₂, S(=O)Ar³, S(=O)₂Ar³, CR²=CR²Ar³, CN, NO₂, Si(R²)₃, B(OR²)₂, B(R²)₂, B(N(R²)₂)₂, OSO₂R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Kombination dieser Systeme; dabei können zwei oder mehrere benachbarte Substituenten R¹ auch miteinander ein mono- oder polycyclisches, aliphatisches oder aromatisches Ringsystem bilden;
Ar³ ist bei jedem Auftreten gleich oder verschieden ein aromatisches oder heteroaromatisches Ringsystem mit 5 bis 40 aromatischen Ringatomen, das mit einem oder mehreren Resten R² substituiert sein kann;
R² ist bei jedem Auftreten gleich oder verschieden H, D, CN oder ein aliphatischer, aromatischer und/oder heteroaromatischer Kohlenwasserstoffrest mit 1 bis 20 C-Atomen, in dem auch H-Atome durch D oder F ersetzt sein können; dabei können zwei oder mehrere benachbarte Substituenten R² auch miteinander ein mono- oder polycyclisches, aliphatisches oder aromatisches Ringsystem bilden;
oder **dadurch gekennzeichnet, dass** das elektronenleitende Matrixmaterial in Emitterschicht 2 ausgewählt ist aus Verbindungen der Formel (21), 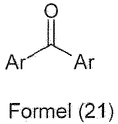 wobei R¹ die oben genannte Bedeutung aufweist und Ar bei jedem Auftreten gleich oder verschieden ein aromatisches oder heteroaromatisches Ringsystem mit 5 bis 60 aromatischen Ringatomen darstellt, welches jeweils mit einer oder mehreren Gruppen R¹ substituiert sein kann.

9. Organische Elektrolumineszenzvorrichtung nach einem oder mehreren der Ansprüche 1 bis 8, **dadurch gekennzeichnet, dass** das lochleitende Matrixmaterial in Emitterschicht 1 ausgewählt ist aus den Verbindungen der Formeln (26) bis (32), 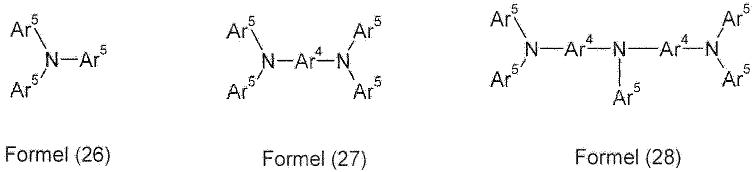 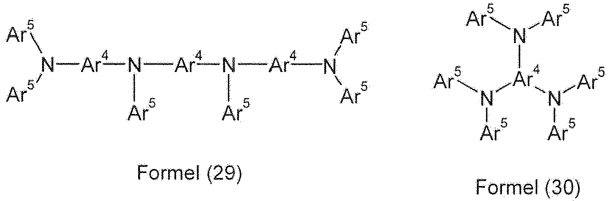 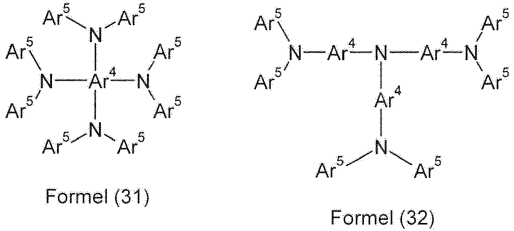 wobei R¹ die oben genannte Bedeutung hat und für die weiteren verwendeten Symbole gilt:
Ar⁴ ist bei jedem Auftreten gleich oder verschieden ein bivalentes, trivalentes oder tetravalentes aromatisches oder heteroaromatisches Ringsystem mit 5 bis 60 aromatischen Ringatomen, welches durch einen oder mehrere Reste R¹ substituiert sein kann;
Ar⁵ ist bei jedem Auftreten gleich oder verschieden ein monovalentes aromatisches oder heteroaromatisches Ringsystem mit 5 bis 60 aromatischen Ringatomen, welches durch einen oder mehrere Reste R¹ substituiert sein kann, dabei können zwei Gruppen Ar⁵, welche an dasselbe Stickstoffatom binden, oder eine Gruppe Ar⁴ mit einer Gruppe Ar⁵, welche an dasselbe Stickstoffatom binden, miteinander durch eine Einfachbindung oder eine Brücke, ausgewählt aus der Gruppe bestehend aus B(R¹), C(R¹)₂, Si(R¹)₂, C=O, C=NR¹, C=C(R¹)₂, O, S, S=O, SO₂, N(R¹), P(R¹) und P(=O)R¹, verknüpft sein können;
oder aus den Verbindungen der Formeln (33) und (34), 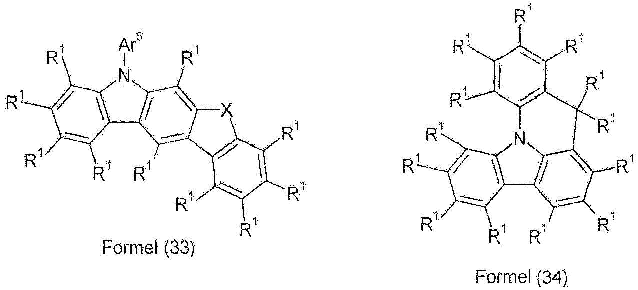 wobei die verwendeten Symbole die oben genannten Bedeutungen aufweisen.

10. Organische Elektrolumineszenzvorrichtung nach einem oder mehreren der Ansprüche 1 bis 9, **dadurch gekennzeichnet, dass** als phosphoreszierende Verbindung mindestens eine Verbindung der Formeln (35) bis (38) vorliegt, 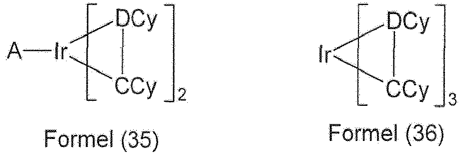 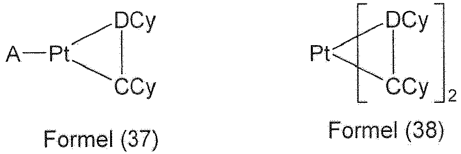 wobei R¹ dieselbe Bedeutung hat, wie in Anspruch 10 beschrieben, und für die weiteren Symbole gilt:
DCy ist gleich oder verschieden bei jedem Auftreten eine cyclische Gruppe, die mindestens ein Donoratom, bevorzugt Stickstoff, Kohlenstoff in Form eines Carbens oder Phosphor, enthält, über welches die cyclische Gruppe an das Metall gebunden ist, und die wiederum einen oder mehrere Substituenten R¹ tragen kann; die Gruppen DCy und CCy sind über eine kovalente Bindung miteinander verbunden;
CCy ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹ tragen kann;
A ist gleich oder verschieden bei jedem Auftreten ein monoanionischer, zweizähnig chelatisierender Ligand, bevorzugt ein Diketonatligand.

11. Organische Elektrolumineszenzvorrichtung nach einem oder mehreren der Ansprüche 1 bis 10, **dadurch gekennzeichnet, dass** die Ladungserzeugungsschicht dadurch gebildet wird, dass eine n-leitende Schicht und eine p-leitende Schicht miteinander gekoppelt werden, wobei die p-leitende Schicht p dotierte organische Lochtransportmaterialien umfasst oder anorganische Materialien umfasst und die n-leitende Schicht eine dotierte organische Elektronentransportschicht ist.

12. Verfahren zur Herstellung einer organischen Elektrolumineszenzvorrichtung nach einem oder mehreren der Ansprüche 1 bis 11, **dadurch gekennzeichnet, dass** eine oder mehrere Schichten mit einem Sublimationsverfahren oder mit dem Organic Vapour Phase Deposition Verfahren oder mit Hilfe einer Trägergassublimation oder aus Lösung oder mit einem beliebigen Druckverfahren hergestellt werden.

## Claims

1. Organic electroluminescent device comprising, in this sequence: anode, phosphorescent emitter layer 1, phosphorescent emitter layer 2, which is in direct contact with emitter layer 1, and cathode, **characterised in that** emitter layer 1 comprises a hole-conducting matrix material and two different phosphorescent emitters and emitter layer 2 comprises an electron-conducting matrix material and a phosphorescent emitter, where the phosphorescent emitter of emitter layer 2 has the same emission maximum as the shorter-wave phosphorescent emitter of emitter layer 1, **characterised in that** it is a white-emitting tandem OLED which additionally has a blue-fluorescent emitter layer and which has a charge-generation layer between the blue-fluorescent emitter layer and emitter layer 2

2. Organic electroluminescent device according to Claim 1, **characterised in that** the phosphorescent emitter of emitter layer 2 is identical to the shorter-wave phosphorescent emitter of emitter layer 1.

3. Organic electroluminescent device according to Claim 1 or 2, **characterised in that** phosphorescent emitter layer 1 is a yellow-, orange- or red-emitting layer and phosphorescent emitter layer 2 is a green- or yellow-emitting layer.

4. Organic electroluminescent device according to one or more of Claims 1 to 3, **characterised in that** emitter layer 1 and emitter layer 2 in total emit light having colour coordinates 0.45 ≤ CIE x ≤ 0.58.

5. Organic electroluminescent device according to one or more of Claims 1 to 4, **characterised in that** the triplet energy T₁ of the hole-conducting matrix material is greater than that of the longest-wave emitter.

6. Organic electroluminescent device according to one or more of Claims 1 to 5, **characterised in that** emitter layer 2 comprises a mixture of an electron-conducting matrix material and at least one further matrix material.

7. Organic electroluminescent device according to one or more of Claims 1 to 6, **characterised in that** the shorter-wave phosphorescent emitter is present in emitter layer 1 in a concentration of 3 to 25% by vol. and the longer-wave phosphorescent emitter is present in emitter layer 1 in a concentration of 2 to 15% by vol., and **in that** the phosphorescent emitter is present in emitter layer 2 in a concentration of 2 to 20% by vol.

8. Organic electroluminescent device according to Claim 7, **characterised in that** the electron-conducting matrix material in emitter layer 2 is selected from compounds of the formulae (1) to (5), 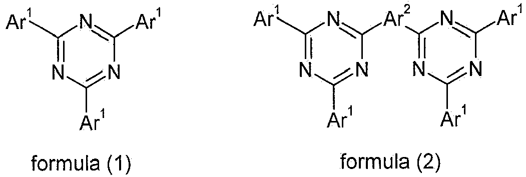 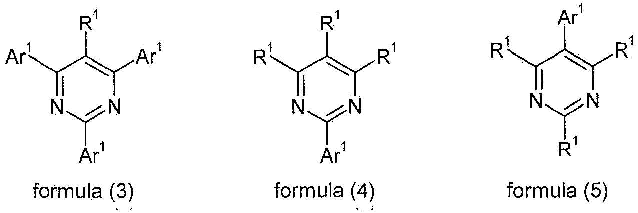 where the following applies to the symbols used:
Ar¹ is, identically or differently on each occurrence, a monovalent aromatic or heteroaromatic ring system having 5 to 60 aromatic ring atoms, which may in each case be substituted by one or more radicals R¹;
Ar² is a divalent aromatic or heteroaromatic ring system having 5 to 60 aromatic ring atoms, which may be substituted by one or more radicals R¹;
R¹ is on each occurrence, identically or differently, H, D, F, Cl, Br, I, CHO, C(=O)Ar³, P(=O)(Ar³)₂, S(=O)Ar³, S(=O)₂Ar³, CR²=CR²Ar³, CN, NO₂, Si(R²)₃, B(OR²)₂, B(R²)₂, B(N(R²)₂)₂, OSO₂R², a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R², where one or more non-adjacent CH₂ groups may be replaced by R²C=CR², C≡C, Si(R²)₂, Ge(R²)₂, Sn(R²)₂, C=O, C=S, C=Se, C=NR², P(=O)(R²), SO, SO₂, NR², O, S or CONR² and where one or more H atoms may be replaced by D, F, Cl, Br, I, CN or NO₂, or an aromatic or heteroaromatic ring system having 5 to 60 aromatic ring atoms, which may in each case be substituted by one or more radicals R², or an aryloxy or hetero-aryloxy group having 5 to 60 aromatic ring atoms, which may be substituted by one or more radicals R², or a combination of these systems; two or more adjacent substituents R¹ may also form a mono- or polycyclic, aliphatic or aromatic ring system with one another;
Ar³ is on each occurrence, identically or differently, an aromatic or heteroaromatic ring system having 5 to 40 aromatic ring atoms, which may be substituted by one or more radicals R²;
R² is on each occurrence, identically or differently, H, D, CN or an aliphatic, aromatic and/or heteroaromatic hydrocarbon radical having 1 to 20 C atoms, in which, in addition, H atoms may be replaced by D or F; two or more adjacent substituents R² may also form a mono- or polycyclic, aliphatic or aromatic ring system with one another;
or **characterised in that** the electron-conducting matrix material in emitter layer 2 is selected from compounds of the formula (21), 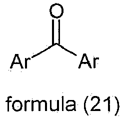 where R¹ has the above-mentioned meaning, and Ar on each occurrence, identically or differently, represents an aromatic or heteroaromatic ring system having 5 to 60 aromatic ring atoms, which may in each case be substituted by one or more groups R¹.

9. Organic electroluminescent device according to one or more of Claims 1 to 8, **characterised in that** the hole-conducting matrix material in emitter layer 1 is selected from the compounds of the formulae (26) to (32), 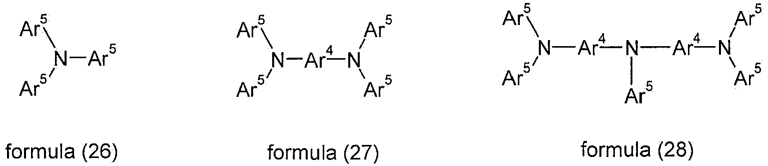 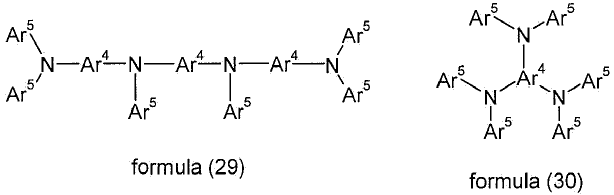 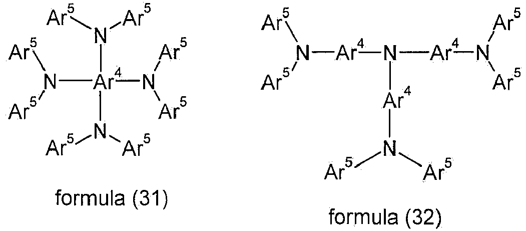 where R¹ has the above-mentioned meaning, and the following applies to the other symbols used:
Ar⁴ is on each occurrence, identically or differently, a divalent, trivalent or tetravalent aromatic or heteroaromatic ring system having 5 to 60 aromatic ring atoms, which may be substituted by one or more radicals R¹;
Ar⁵ is on each occurrence, identically or differently, a monovalent aromatic or heteroaromatic ring system having 5 to 60 aromatic ring atoms, which may be substituted by one or more radicals R¹, two groups Ar⁵ which are bonded to the same nitrogen atom or a group Ar⁴ with a group Ar⁵ which are bonded to the same nitrogen atom may be linked to one another here by a single bond or a bridge selected from the group consisting of B(R¹), C(R¹)₂, Si(R¹)₂, C=O, C=NR¹, C=C(R¹)₂, O, S, S=O, SO₂, N(R¹), P(R¹) and P(=O)R¹;
or from the compounds of the formulae (33) and (34), 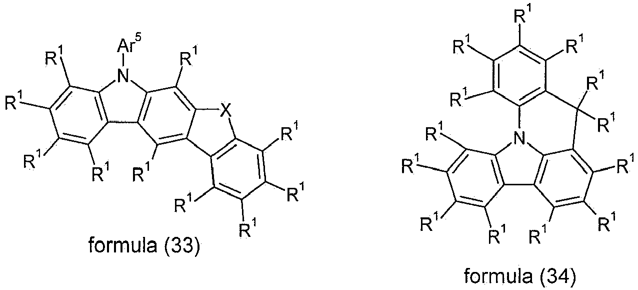 where the symbols used have the above-mentioned meanings.

10. Organic electroluminescent device according to one or more of Claims 1 to 9, **characterised in that** the phosphorescent compound present is at least one compound of the formulae (35) to (38), 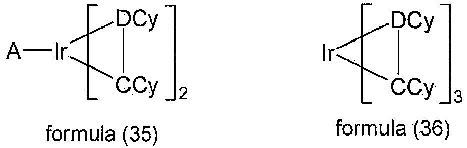 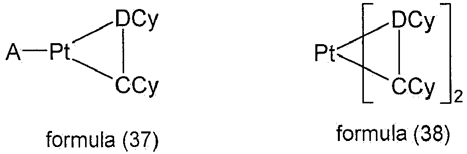 where R¹ has the same meaning as described in Claim 10, and the following applies to the other symbols:
DCy is, identically or differently on each occurrence, a cyclic group which contains at least one donor atom, preferably nitrogen, carbon in the form of a carbene or phosphorus, via which the cyclic group is bonded to the metal, and which may in turn carry one or more substituents R¹; the groups DCy and CCy are connected to one another via a covalent bond;
CCy is, identically or differently on each occurrence, a cyclic group which contains a carbon atom via which the cyclic group is bonded to the metal and which may in turn carry one or more substituents R¹;
A is, identically or differently on each occurrence, a monoanionic, bidentate-chelating ligand, preferably a diketonate ligand.

11. Organic electroluminescent device according to one or more of Claims 1 to 10, **characterised in that** the charge-generation layer is formed by coupling an n-conducting layer and a p-conducting layer to one another, where the p-conducting layer comprises p-doped organic hole-transport materials or comprises inorganic materials and the n-conducting layer is a doped organic electron-transport layer.

12. Process for the production of an organic electroluminescent device according to one or more of Claims 1 to 11, **characterised in that** one or more layers are produced by means of a sublimation process or by means of the organic vapour-phase deposition process or with the aid of carrier-gas sublimation or from solution or by means of any desired printing process.

## Revendications

1. Dispositif électroluminescent organique comprenant, selon cette séquence : une anode, une couche d'émetteur phosphorescent 1, une couche d'émetteur phosphorescent 2, laquelle est en contact direct avec la couche d'émetteur 1, et une cathode, **caractérisé en ce que** la couche d'émetteur 1 comprend un matériau de matrice de conduction de trous et deux émetteurs phosphorescents différents et la couche d'émetteur 2 comprend un matériau de matrice de conduction d'électrons et un émetteur phosphorescent, dans lequel l'émetteur phosphorescent de la couche d'émetteur 2 présente le même maximum d'émission que l'émetteur phosphorescent à onde plus courte de la couche d'émetteur 1, **caractérisé en ce qu'**il s'agit d'une OLED en tandem à émission de blanc, laquelle comporte de façon additionnelle une couche d'émetteur à émission fluorescente de bleu et laquelle comporte une couche de génération de charges entre la couche d'émetteur à émission fluorescente de bleu et la couche d'émetteur 2

2. Dispositif électroluminescent organique selon la revendication 1, **caractérisé en ce que** l'émetteur phosphorescent de la couche d'émetteur 2 est identique à l'émetteur phosphorescent à onde plus courte de la couche d'émetteur 1.

3. Dispositif électroluminescent organique selon la revendication 1 ou 2, **caractérisé en ce que** la couche d'émetteur phosphorescent 1 est une couche à émission de jaune, d'orange ou de rouge et la couche d'émetteur phosphorescent 2 est une couche à émission de vert ou de jaune.

4. Dispositif électroluminescent organique selon une ou plusieurs des revendications 1 à 3, **caractérisé en ce que** la couche d'émetteur 1 et la couche d'émetteur 2 émettent au total une lumière qui présente des coordonnées de couleur(s) 0,45 ≤ CIE x ≤ 0,58.

5. Dispositif électroluminescent organique selon une ou plusieurs des revendications 1 à 4, **caractérisé en ce que** l'énergie de triplet T₁ du matériau de matrice de conduction de trous est supérieure à celle de l'émetteur à onde la plus longue.

6. Dispositif électroluminescent organique selon une ou plusieurs des revendications 1 à 5, **caractérisé en ce que** la couche d'émetteur 2 comprend un mélange constitué par un matériau de matrice de conduction d'électrons et par au moins un autre matériau de matrice.

7. Dispositif électroluminescent organique selon une ou plusieurs des revendications 1 à 6, **caractérisé en ce que** l'émetteur phosphorescent à onde plus courte est présent dans la couche d'émetteur 1 selon une concentration de 3 à 25 % en volume et l'émetteur phosphorescent à onde plus longue est présent dans la couche d'émetteur 1 selon une concentration de 2 à 15 % en volume, et **en ce que** l'émetteur phosphorescent est présent dans la couche d'émetteur 2 de selon une concentration de 2 à 20 % en volume.

8. Dispositif électroluminescent organique selon la revendication 7, **caractérisé en ce que** le matériau de matrice de conduction d'électrons dans la couche d'émetteur 2 est sélectionné parmi les composés des formules (1) à (5) : 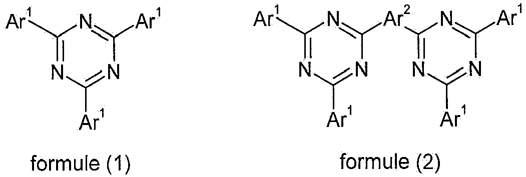 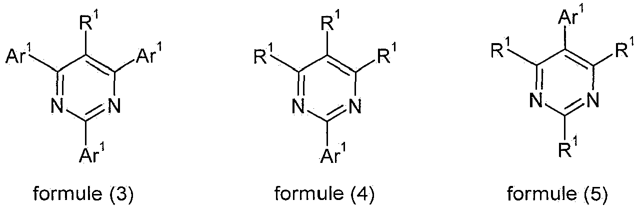 dans lesquelles ce qui suit s'applique aux symboles qui sont utilisés :
Ar¹ est, de manière identique ou différente pour chaque occurrence, un système de cycle aromatique ou hétéroaromatique monovalent qui comporte de 5 à 60 atomes de cycle aromatique, lequel peut dans chaque cas être substitué par un radical ou par plusieurs radicaux R¹ ;
Ar² est un système de cycle aromatique ou hétéroaromatique divalent qui comporte de 5 à 60 atomes de cycle aromatique, lequel peut être substitué par un radical ou par plusieurs radicaux R¹ ;
R¹ est pour chaque occurrence, de manière identique ou différente, H, D, F, Cl, Br, I, CHO, C(=O)Ar³, P(=O)(Ar³)₂, S(=O)Ar³, S(=O)₂Ar³, CR²=CR²Ar³, CN, NO₂, Si(R²)₃, B(OR²)₂, B(R²)₂, B(N(R²)₂)₂, OSO₂R², un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R², où un ou plusieurs groupe(s) CH₂ non adjacents peut/peuvent être remplacé(s) par R²C=CR², C≡C, Si(R²)₂, Ge(R²)₂, Sn(R²)₂, C=O, C=S, C=Se, C=NR², P(=O)(R²), SO, SO₂, NR², O, S ou CONR² et où un ou plusieurs atome(s) de H peut/peuvent être remplacé(s) par D, F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R², ou un groupe aryloxy ou hétéroaryloxy qui comporte de 5 à 60 atomes de cycle aromatique, lequel peut être substitué par un radical ou par plusieurs radicaux R², ou une combinaison de ces systèmes ; deux substituants R¹ adjacents ou plus peuvent également former un système de cycle aliphatique ou aromatique monoou polycyclique l'un avec l'autre ou les uns avec les autres ;
Ar³ est pour chaque occurrence, de manière identique ou différente, un système de cycle aromatique ou hétéroaromatique qui comporte de 5 à 40 atomes de cycle aromatique, lequel peut être substitué par un radical ou par plusieurs radicaux R² ;
R² est pour chaque occurrence, de manière identique ou différente, H, D, CN ou un radical hydrocarbone aliphatique, aromatique et/ou hétéroaromatique qui comporte de 1 à 20 atome(s) de C, où, en outre, des atomes de H peuvent être remplacés par D ou F; deux substituants R² adjacents ou plus peuvent également former un système de cycle aliphatique ou aromatique mono- ou polycyclique l'un avec l'autre ou les uns avec les autres ;
où **caractérisé en ce que** le matériau de matrice de conduction d'électrons dans la couche d'émetteur 2 est sélectionné parmi les composés de la formule (21) : 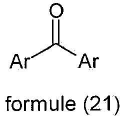 dans laquelle R¹ présente la signification qui a été mentionnée ci-avant, et Ar représente pour chaque occurrence, de manière identique ou différente, un système de cycle aromatique ou hétéroaromatique qui comporte de 5 à 60 atomes de cycle aromatique, lequel peut dans chaque cas être substitué par un ou plusieurs groupe(s) R¹.

9. Dispositif électroluminescent organique selon une ou plusieurs des revendications 1 à 8, **caractérisé en ce que** le matériau de matrice de conduction de trous dans la couche d'émetteur 1 est sélectionné parmi les composés des formules (26) à (32) : 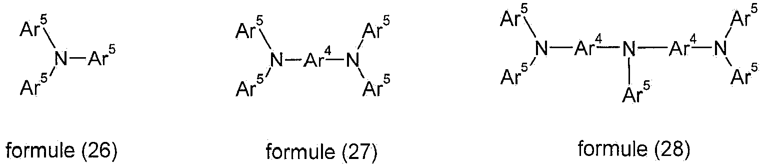 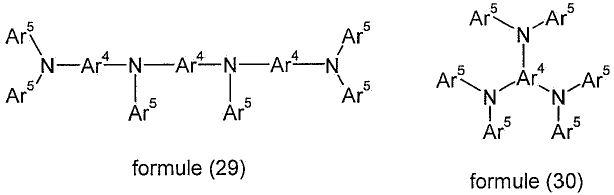 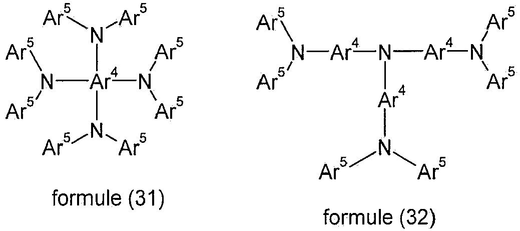 dans lesquelles R¹ présente la signification qui a été mentionnée ci-avant, et ce qui suit s'applique aux autres symboles qui sont utilisés :
Ar⁴ est pour chaque occurrence, de manière identique ou différente, un système de cycle aromatique ou hétéroaromatique divalent, trivalent ou tétravalent qui comporte de 5 à 60 atomes de cycle aromatique, lequel peut être substitué par un radical ou par plusieurs radicaux R¹ ;
Ar⁵ est pour chaque occurrence, de manière identique ou différente, un système de cycle aromatique ou hétéroaromatique monovalent qui comporte de 5 à 60 atomes de cycle aromatique, lequel peut être substitué par un radical ou par plusieurs radicaux R¹, deux groupes Ar⁵ qui sont liés au même atome d'azote ou un groupe Ar⁴ avec un groupe Ar⁵ qui sont liés au même atome d'azote peuvent être reliés l'un à l'autre ici au moyen d'une liaison simple ou d'un pont sélectionné parmi le groupe qui est constitué par B(R¹), C(R¹)₂, Si(R¹)₂, C=O, C=NR¹, C=C(R¹)₂, O, S, S=O, SO₂, N(R¹), P(R¹) et P(=O)R¹ ;
ou parmi les composés des formules (33) et (34) : 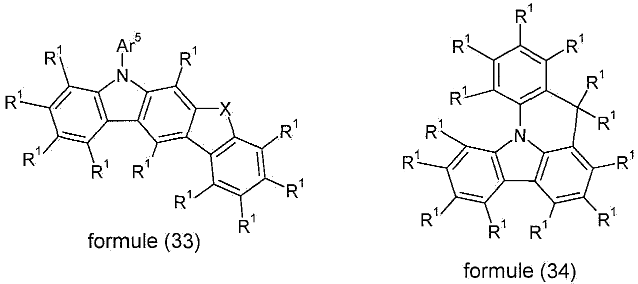 dans lesquelles les symboles qui sont utilisés présentent les significations qui ont été mentionnées ci-avant.

10. Dispositif électroluminescent organique selon une ou plusieurs des revendications 1 à 9, **caractérisé en ce que** le composé phosphorescent présent est au moins un composé des formules (35) à (38) : 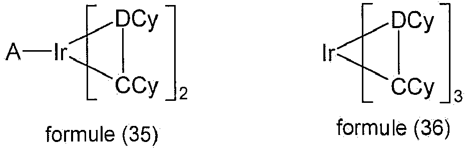 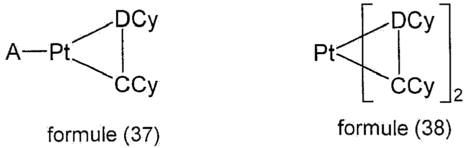 dans lesquelles R¹ présente la même signification que décrit selon la revendication 10, et ce qui suit s'applique aux autres symboles :
DCy est, de manière identique ou différente pour chaque occurrence, un groupe cyclique qui contient au moins un atome donneur, de préférence azote, carbone sous la forme d'un carbène ou phosphore, via lequel le groupe cyclique est lié au métal, et lequel peut à son tour être porteur d'un ou de plusieurs substituant(s) R¹ ; les groupes DCy et CCy sont connectés l'un à l'autre via une liaison covalente ;
CCy est, de manière identique ou différente pour chaque occurrence, un groupe cyclique qui contient un atome de carbone via lequel le groupe cyclique est lié au métal et lequel peut à son tour être porteur d'un ou de plusieurs substituant(s) R¹ ;
A est, de manière identique ou différente pour chaque occurrence, un ligand monoanionique chélatant bidenté, de préférence un ligand dicétonate.

11. Dispositif électroluminescent organique selon une ou plusieurs des revendications 1 à 10, **caractérisé en ce que** la couche de génération de charges est formée en couplant une couche de conduction n et une couche de conduction p l'une à l'autre, où la couche de conduction p comprend des matériaux de transport de trous organiques dopés p ou comprend des matériaux inorganiques et la couche de conduction n est une couche de transport d'électrons organique dopée.

12. Procédé pour la fabrication d'un dispositif électroluminescent organique selon une ou plusieurs des revendications 1 à 11, **caractérisé en ce qu'**une ou plusieurs couche(s) est/sont produite(s) au moyen d'un processus de sublimation ou au moyen du processus de dépôt d'organiques en phase vapeur ou à l'aide d'une sublimation par gaz porteur ou à partir d'une solution ou au moyen d'un quelconque processus d'impression souhaité.
